# EUROPEAN PATENT APPLICATION

(11) **EP 4 261 887 A1**
(43) Date of publication of application: **18.10.2023**
(21) Application number: 23166209.9
(22) Date of filing: 31.03.2023
(51) Int. Cl.: H01L 25/075, H01L 33/62

(54) **DISPLAY DEVICE**

(30) Priority: 08.04.2022 KR 20220043927
(71) Applicant: Samsung Display Co., Ltd., Yongin-si, Gyeonggi-do 17113 (KR)
(72) Inventor: SON, Yong Duck, 17113 Yongin-si (KR); BAEK, Won Bong, 17113 Yongin-si (KR); AN, Sang Woo, 17113 Yongin-si (KR); LEE, Kye Uk, 17113 Yongin-si (KR); JANG, Won Ho, 17113 Yongin-si (KR); CHOI, Nak Cho, 17113 Yongin-si (KR)
(74) Representative: Taor, Simon Edward William

(57) **Abstract**

A display device includes, a substrate including a first surface and a second surface opposite to the first surface; a light emitting element on the first surface of the substrate; a top surface pad on the first surface of the substrate and spaced from the light emitting element; a driving circuit on the second surface of the substrate to apply a driving signal for driving the light emitting element; a top surface connection line between the first surface of the substrate and the top surface pad to electrically connect the top surface pad to the light emitting element; an interlayer insulating layer between the top surface connection line and the top surface pad; and a side wiring on the top surface pad to connect the top surface pad to the driving circuit.

## Description

### BACKGROUND

### 1. Field

The present disclosure relates to a display device and a manufacturing method of the same.

### 2. Description of the Related Art

An electronic device such as a smart phone, a tablet PC, a digital camera, a laptop computer, a navigation system and a smart television, which provides an image to a user, includes a display device for displaying an image.

The display device includes a display area capable of expressing various colors while operating in units of pixels or sub-pixels, and a bezel area in which lines for driving the pixels or the sub-pixels are disposed.

Recently, the demand for a bezel-less technology that reduces or eliminates the bezel area to maximize the display area in a display device is increasing, and research and development for a side wiring forming technology for forming a line on a side surface of a substrate have been steadily progressed in response thereto.

### SUMMARY

Aspects and features of embodiments of the present disclosure provide a display device that prevents corrosion of a side wiring.

However, aspects and features of embodiments of the present disclosure are not restricted to the one set forth herein. The above and other aspects of the present disclosure will become more apparent to one of ordinary skill in the art to which the present disclosure pertains by referencing the detailed description of the present disclosure given below.

According to one or more embodiments of the present disclosure, a display device includes a substrate including a first surface and a second surface opposite to the first surface; a light emitting element on the first surface of the substrate; a top surface pad on the first surface of the substrate and spaced from the light emitting element; a driving circuit on the second surface of the substrate to apply a driving signal for driving the light emitting element; a top surface connection line between the first surface of the substrate and the top surface pad to electrically connect the top surface pad to the light emitting element; an interlayer insulating layer between the top surface connection line and the top surface pad; and a side wiring on the top surface pad to connect the top surface pad to the driving circuit, wherein the top surface pad includes: a first region in direct contact with the top surface connection line through a contact hole penetrating the interlayer insulating layer; and a second region that does not overlap the top surface connection line, wherein the side wiring overlaps the second region of the top surface pad and does not overlap the first region.

In one or more embodiments, the top surface pad has a planar profile in which a stepped portion is located along the contact hole in the first region, and has a flat planar profile in the second region.

In one or more embodiment, the top surface pad includes a first pad electrode; and a second pad electrode on the first pad electrode.

In one or more embodiments, in the second region, the second pad electrode completely covers the first pad electrode.

In one or more embodiments, a standard reduction potential value of metal contained in the first pad electrode and a standard reduction potential value of metal contained in the side wiring are different from each other.

In one or more embodiments, the first pad electrode contains aluminum (Al), the second pad electrode contains a transparent conductive oxide, and the side wiring contains silver (Ag).

In one or more embodiments, a display device may further include a passivation layer on the top surface pad, wherein the passivation layer includes a first pad opening exposing the second pad electrode in the first region of the top surface pad; and a second pad opening exposing the second pad electrode in the second region of the top surface pad.

In one or more embodiments, the light emitting element is a flip chip type micro light emitting diode.

According to one or more embodiments, a display device includes, a substrate including a first surface and a second surface opposite to the first surface, a first chamfered surface extending from one side of the first surface, a second chamfered surface extending from one side of the second surface, and a first side surface connecting the first chamfered surface to the second chamfered surface; a light emitting element on the first surface of the substrate; a first pad on the first surface of the substrate and spaced from the light emitting element; a top surface connection line between the first surface of the substrate and the first pad to electrically connect the first pad to the light emitting element; a driving circuit on the second surface of the substrate to apply a driving signal for driving the light emitting element; and a side wiring on the first pad to electrically connect the first pad to the driving circuit, wherein the top surface connection line includes a first contact portion electrically connected to the first pad; and a first peeling portion extending in a direction toward the first chamfered surface from the first contact portion, wherein the side wiring does not overlap the top surface connection line.

In one or more embodiment, the first peeling portion extends on the first surface to a vicinity of a boundary between the first surface and the first chamfered surface.

In one or more embodiment, the side wiring is on the first surface, the first side surface, and the second surface of the substrate; the display device further including a second pad between the side wiring and the second surface of the substrate and electrically connected to the side wiring.

In one or more embodiments, the second pad includes: a first portion overlapping the side wiring; and a second portion spaced from the first portion without overlapping the side wiring, wherein the second portion of the second pad includes: a second contact portion in contact with the side wiring; and a second peeling portion extending in a direction toward the second chamfered surface from the second contact portion.

In one or more embodiments, the second peeling portion extends on the second surface to a vicinity of a boundary between the second surface and the second chamfered surface.

In one or more embodiments, a display device may further include a bottom surface connection line between the second pad and the second surface of the substrate, wherein the bottom surface connection line includes: a pad electrode portion electrically connecting the first portion and the second portion of the second pad; and a line portion electrically connecting the second portion to the driving circuit.

According to one or more embodiments of the present disclosure, a tiled display device including a plurality of display devices and a seam located between the plurality of display devices, wherein a first display device from among the plurality of display devices includes: a substrate including a first surface and a second surface opposite to the first surface, a first chamfered surface extending from one side of the first surface, a second chamfered surface extending from one side of the second surface, and a first side surface connecting the first chamfered surface to the second chamfered surface; light emitting elements on the first surface of the substrate; a first pad on the first surface of the substrate and spaced from the light emitting elements; a top surface connection line between the first surface of the substrate and the first pad to electrically connect the first pad to the light emitting elements; a driving circuit on the second surface of the substrate to apply a driving signal for driving the light emitting elements; and a side wiring on the first pad to electrically connect the first pad to the driving circuit, wherein the first pad includes: a first region overlapping the top surface connection line; and a second region not overlapping the top surface connection line, wherein the side wiring overlaps the second region of the first pad without overlapping the first region.

In one or more embodiments, each of the light emitting elements is a flip chip type micro light emitting diode.

In one or more embodiments, the substrate includes glass.

In one or more embodiments, the side wiring is on the first surface, the second surface, and the first side surface of the substrate.

In one or more embodiment, a tiled display may further include a bottom surface connection line between the side wiring and the second surface of the substrate, wherein one end of the bottom surface connection line is connected to the driving circuit, and the other end of the bottom surface connection line is connected to the side wiring.

In one or more embodiments, the plurality of display devices are arranged in a matrix form in M rows and N columns.

According to an aspect, there is provided a display device as set out in claim 1. Additional features are set out in claims 2 to 6. According to an aspect, there is provided a display device as set out in claim 7. Additional features are set out in claims 8 to 10. According to an aspect, there is provided a tiled display device as set out in claim 11. Additional features are set out in claims 12 to 15.

The display device according to one or more embodiments may prevent corrosion of a side wiring.

However, the effects, aspects, and features of embodiments of the present disclosure are not limited to the aforementioned effects, aspects, and features, and various other effects, aspects, and features are included in the present disclosure.

### BRIEF DESCRIPTION OF THE DRAWINGS

The above and other aspects and features of the present disclosure will become more apparent by describing in detail embodiments thereof with reference to the attached drawings, in which:
FIG. 1 is a perspective view illustrating a front surface of a display device according to one or more embodiments;
FIG. 2 is a perspective view illustrating a rear surface of a display device according to one or more embodiments;
FIG. 3 is a diagram schematically illustrating a structure of a pixel of a display device according to one or more embodiments;
FIG. 4 is a diagram schematically illustrating a structure of a pixel of a display device according to one or more embodiments;
FIG. 5 is a structural diagram schematically illustrating an example of a cross-sectional structure of a pixel according to one or more embodiments;
FIG. 6 is a perspective view illustrating the arrangement relationship between pixels and side wirings of a display device according to one or more embodiments;
FIG. 7 is a plan view illustrating the arrangement relationship between pixels and side wirings of a display device according to one or more embodiments;
FIG. 8 is an enlarged view of an area A of FIG. 7;
FIG. 9 is a rear view illustrating the arrangement relationship between a driver and side wirings of a display device according to one or more embodiments;
FIG. 10 is an enlarged view of an area B of FIG. 9;
FIG. 11 is a cross-sectional view illustrating a cross section taken along the line X1-X1' of FIGS. 7 and 9;
FIG. 12 is an enlarged view of an area C of FIG. 11;
FIG. 13 is a cross-sectional view illustrating a cross section taken along the line X2-X2' of FIGS. 7 and 9;
FIG. 14 is an enlarged view of an area D of FIG. 13;
FIG. 15 is a cross-sectional view illustrating a cross section taken along the line X3-X3' of FIG. 8;
FIG. 16 is a cross-sectional view illustrating a cross section taken along the line X4-X4' of FIG. 10;
FIGS. 17 to 27 are diagrams illustrating a manufacturing method of a display device according to one or more embodiments;
FIG. 28 is a diagram schematically illustrating a tiled display using display devices according to one or more embodiments;
FIG. 29 is an enlarged view of an area A of FIG. 28;
FIG. 30 is a cross-sectional view illustrating a cross section taken along the line X7-X7' of FIG. 29;
FIG. 31 is a block diagram illustrating a structure of a tiled display according to one or more embodiments;
FIG. 32 is a diagram illustrating a state in which a tiled display using display devices according to one or more embodiments is driven;
FIG. 33 is a structural diagram schematically illustrating a structure of a second region of a first pad of a display device according to one or more embodiments; and
FIG. 34 is a plan view schematically illustrating a planar profile shape of a first pad of a display device according to one or more embodiments.

### DETAILED DESCRIPTION

The present disclosure will now be described more fully hereinafter with reference to the accompanying drawings, in which embodiments of the present disclosure are shown. The present disclosure may, however, be embodied in different forms and should not be construed as limited to the embodiments set forth herein. Rather, these embodiments are provided so that the present disclosure will be thorough and complete, and will fully convey the scope of the present disclosure to those skilled in the art.

It will also be understood that when a layer is referred to as being "on" another layer or substrate, it can be directly on the other layer or substrate, or intervening layers may also be present. The same reference numbers indicate the same components throughout the specification.

It will be understood that, although the terms "first," "second," etc. may be used herein to describe various elements, these elements should not be limited by these terms. These terms are only used to distinguish one element from another element. For instance, a first element discussed below could be termed a second element without departing from the teachings of the present disclosure. Similarly, the second element could also be termed the first element.

Features of each of various embodiments of the present disclosure may be partially or entirely combined with each other and may technically variously interwork with each other, and respective embodiments may be implemented independently of each other or may be implemented together in association with each other.

Hereinafter, illustrative embodiments will be described in detail with reference to the accompanying drawings.

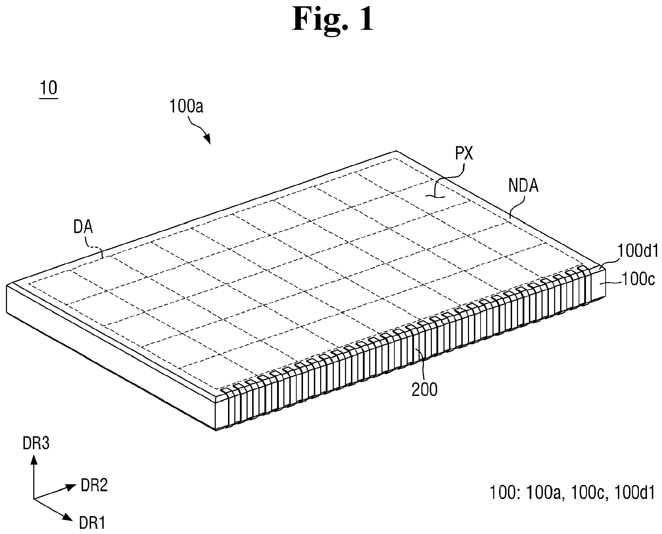

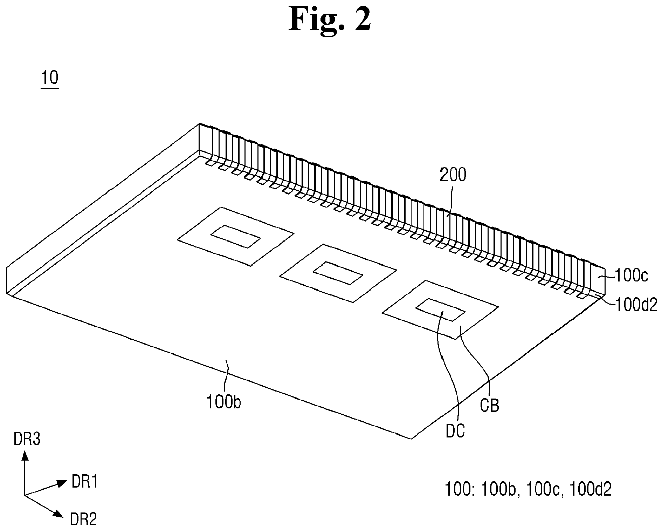

FIG. 1 is a perspective view illustrating a front surface of a display device according to one or more embodiments. FIG. 2 is a perspective view illustrating a rear surface of a display device according to one or more embodiments.

A first direction DR1, a second direction DR2, and a third direction DR3 are defined as shown in FIG. 1. The first direction DR1 and the second direction DR2 may be perpendicular to each other, the first direction DR1 and the third direction DR3 may be perpendicular to each other, and the second direction DR2 and the third direction DR3 may be perpendicular to each other. It may be understood that the first direction DR1 refers to a vertical direction in the drawing, the second direction DR2 refers to a horizontal direction in the drawing, and the third direction DR3 refers to an upward and downward direction (i.e., a thickness direction) in the drawing. In the following specification, unless otherwise stated, "direction" may refer to both directions extending along the direction. Further, when it is necessary to distinguish both "directions" extending in both sides, one side will be referred to as "one side in the direction" and the other side will be referred to as "the other side in the direction." Referring to FIG. 1, a direction in which an arrow is directed is referred to as one side, and the opposite direction is referred to as the other side.

Hereinafter, for simplicity of description, in referring to a display device 10 or the surfaces of each member constituting the display device 10, one surface facing one side in the direction in which an image is displayed, i.e., the third direction DR3, is referred to as a top surface, and the other surface opposite to the one surface is referred to as a bottom surface. However, embodiments of the present disclosure are not limited thereto, and the one surface and the other surface of the member may be referred to as a front surface and a rear surface, respectively, or may be referred to as a first surface or a second surface, respectively. Further, in describing the relative position of each member of the display device 10, one side in the third direction DR3 may be referred to as an upper side and the other side in the third direction DR3 may be referred to as a lower side.

Referring to FIGS. 1 and 2, a display device 10 according to one or more embodiments may be applied to portable electronic devices such as a mobile phone, a smartphone, a tablet personal computer, a mobile communication terminal, an electronic organizer, an electronic book, a portable multimedia player (PMP), a navigation system, an ultra -mobile PC (UMPC) or the like. Alternatively, the display device 10 according to one or more embodiments may be applied as a display unit of a television, a laptop, a monitor, a billboard, or an Internet-of-Things (IoT) terminal.

The display device 10 may have a planar shape similar to a quadrilateral shape. For example, the display device 10 may have a planar shape similar to a rectangular shape having short sides in the first direction DR1 and long sides in the second direction DR2, as shown in FIG. 1. A corner where the short side in the first direction DR1 and the long side in the second direction DR2 meet may be right-angled or rounded with a suitable curvature (e.g., predetermined curvature). The planar shape of the display device 10 of embodiments is not limited to a quadrilateral shape, and may be formed in a shape similar to another polygonal shape, a circular shape, or elliptical shape.

The display device 10 may include a display area DA in which an image is displayed on one surface (hereinafter, referred to as 'top surface') in the third direction DR3, and a non-display area NDA in which no image is displayed, which is an area other than the display area DA. Specifically, the non-display area NDA may be disposed on a part of the top surface of the display device 10, both side surfaces (hereinafter, referred to as 'side surfaces') of the display device 10 in the second direction DR2, both side surfaces thereof in the first direction DR1, and the other side surface (hereinafter, referred to as 'bottom surface') thereof in the third direction DR3, but embodiments of the present disclosure are not limited thereto. In one or more embodiments, the non-display area NDA may be disposed to be around (e.g., to surround) an edge or periphery of the display area DA, but embodiments of the present disclosure are not limited thereto. In one or more embodiments, the display area DA and the non-display area NDA of the display device 10 may also be applied to a substrate 100 to be described later.

The display device 10 according to one or more embodiments may include the substrate 100, a plurality of pixels PX, a plurality of side wirings 200, and a driver, and the driver may include a circuit board CB and a display driving circuit DC.

The substrate 100 may serve as a base of the display device 10. In one or more embodiments, the substrate 100 may contain glass as a rigid substrate having rigidity, but embodiments of the present disclosure are not limited thereto. For example, the substrate 100 may contain polyimide as a flexible substrate having flexibility. Hereinafter, for simplicity of description, a case where the substrate 100 contains glass as a rigid substrate will be mainly described.

The substrate 100 may have a three-dimensional shape similar to a rectangular parallelepiped, in which corners formed by a top surface and side surfaces of the rectangular parallelepiped and corners formed by a bottom surface and the side surfaces thereof are bent. In other words, the substrate 100 may have a three-dimensional shape similar to a rectangular parallelepiped, in which the edges of the top and bottom surfaces are bent. FIGS. 1 and 2 illustrate that chamfered surfaces are formed on both sides of the top and bottom surfaces of the substrate 100 in the first and second directions DR1 and DR2. In one or more embodiments, the surfaces of the substrate 100 where the corners are bent, i.e., the chamfered surfaces, may be formed on both sides of the top and bottom surfaces of the substrate 100 in the first direction DR1 and the second direction DR2, but embodiments of the present disclosure are not limited thereto. For example, the chamfered surface may be formed only on one side of the top and bottom surfaces of the substrate 100 in the first direction DR1. Hereinafter, for simplicity of description, a case where the chamfered surfaces are formed on both sides of the top and bottom surfaces of the substrate 100 in the first direction DR1 and the second direction DR2 will be mainly described.

The substrate 100 may include a first surface 100a, a second surface 100b, a plurality of chamfered surfaces, and a plurality of side surfaces.

The first surface 100a may be the top surface of the substrate 100. The first surface 100a may have a rectangular shape with short sides in the first direction DR1 and long sides in the second direction DR2.

The second surface 100b may be the surface opposite to the first surface 100a in the third direction DR3. The second surface 100b may be the bottom surface of the substrate 100. The second surface 100b may have a rectangular shape with short sides in the first direction DR1 and long sides in the second direction DR2.

The plurality of side surfaces, which are disposed between the first surface 100a and the second surface 100b, may be both side surfaces of the substrate 100 in the first direction DR1 and the second direction DR2. For simplicity of description, among the plurality of side surfaces, a side surface disposed on one side in the first direction DR1 is referred to as 'first side surface 100c', a side surface disposed on one side in the second direction DR2 is referred to as 'second side surface', a side surface disposed on the other side in the first direction DR1 is referred to as 'third side surface', and a side surface disposed on the other side in the second direction DR2 is referred to as 'fourth side surface'.

The plurality of chamfered surfaces may refer to obliquely cut surfaces that are disposed between the first surface 100a and the plurality of side surfaces and between the second surface 100b and the plurality of side surfaces in order to prevent occurrence of chipping defects in the plurality of side wirings 200. Due to the plurality of chamfered surfaces, the bending angles of the plurality of side wirings 200 may become gentle, which makes it possible to prevent occurrence of chipping or cracking in the plurality of side wirings 200. For simplicity of description, among the plurality of chamfered surfaces, a chamfered surface disposed between the first surface 100a and the first side surface 100c is referred to as 'first chamfered surface 1 00d1', a chamfered surface disposed between the second surface 100b and the first side surface 100c is referred to as 'second chamfered surface 1 00d2', a chamfered surface disposed between the first surface 100a and the second side surface is referred to as 'third chamfered surface', a chamfered surface disposed between the second surface 100b and the second side surface is referred to as 'fourth chamfered surface', a chamfered surface disposed between the first surface 100a and the third side surface is referred to as 'fifth chamfered surface', a chamfered surface disposed between the second surface 100b and the third side surface is referred to as 'sixth chamfered surface', and a chamfered surface disposed between the first surface 100a and the fourth side surface is referred to as 'seventh chamfered surface', and a chamfered surface disposed between the second surface 100b and the fourth side surface is referred to as 'eighth chamfered surface'.

Specifically, the first chamfered surface 100d1 may extend from one side of the first surface 100a in the first direction DR1, the second chamfered surface 100d2 may extend from one side of the second surface 100b in the first direction DR1, and the first side surface 100c may connect the first chamfered surface 100d1 and the second chamfered surface 100d2. The third chamfered surface may extend from one side of the first surface 100a in the second direction DR2, the fourth chamfered surface may extend from one side of the second surface 100b in the second direction DR2, and the second side surface may connect the third chamfered surface and the fourth chamfered surface. The fifth chamfered surface may extend from the other side of the first surface 100a in the first direction DR1, the sixth chamfered surface may extend from the other side of the second surface 100b in the first direction DR1, and the third side surface may connect the fifth chamfered surface and the sixth chamfered surface. The seventh chamfered surface may extend from the other side of the first surface 100a in the second direction DR2, the eighth chamfered surface may extend from the other side of the second surface 100b in the second direction DR2, and the fourth side surface may connect the seventh chamfered surface and the eighth chamfered surface.

The plurality of pixels PX may be disposed on the first surface 100a of the substrate 100 to display an image. The plurality of pixels PX may be arranged in a matrix form in the first direction DR1 and the second direction DR2. For example, the plurality of pixels PX may be arranged along rows and columns of a matrix in the first direction DR1 and the second direction DR2. The structure of the plurality of pixels PX will be described in detail later.

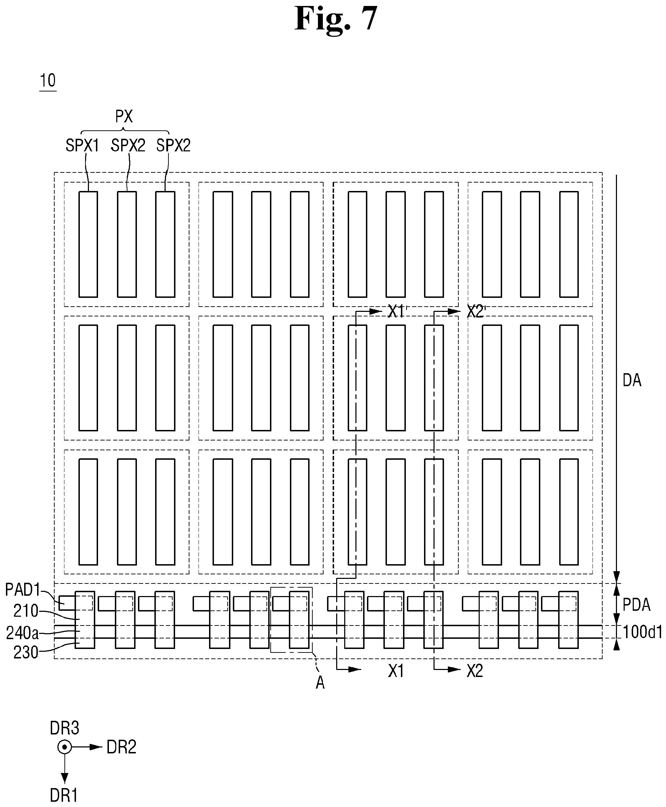

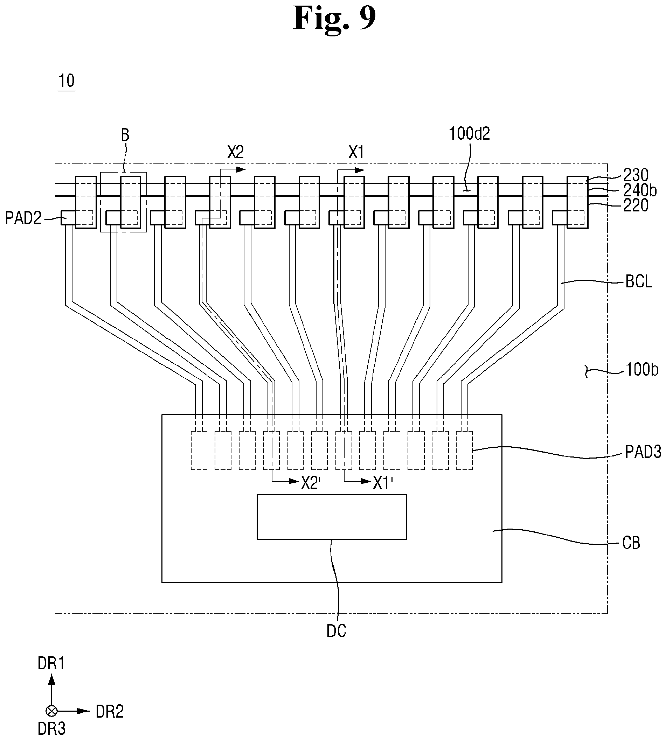

Each of the plurality of side wirings 200 may serve to connect a first pad PAD1 (see FIG. 7) disposed on the first surface 100a and a second pad PAD2 (see FIG. 9) disposed on the second surface 100b. The first pads PAD1 may be connected to data lines connected to the plurality of pixels PXs disposed on the first surface 100a of the substrate 100. The plurality of side wirings 200 may be arranged to be spaced from each other in the second direction DR2.

In one or more embodiments, the term "connected" as used herein may mean not only that one member is connected to another member through a physical contact, but also that one member is connected to another member through yet another member. This may also be understood as one part and the other part as integral elements are connected into an integrated element via another element. Furthermore, if one element is connected to another element, this may be construed as a meaning including an electrical connection via another element in addition to a direct connection in physical contact.

The plurality of side wirings 200 may be disposed on the first surface 100a, the second surface 100b, at least any two chamfered surfaces from among the plurality of chamfered surfaces, and at least any one side surface from among the plurality of side surfaces. For example, as shown in FIGS. 1 and 2, the plurality of side wirings 200 may be disposed on the first surface 100a, the second surface 100b, the first chamfered surface 100d1, the second chamfered surface 100d2, and the first side surface 100c in order to connect the first pads PAD1 disposed on one side of the first surface 100a of the substrate 100 in the first direction DR1 and the second pads PAD2 disposed on one side of the second surface 100b thereof in the first direction DR1. The shape of each of the plurality of side wirings 200 will be described in detail later.

In one or more embodiments, the plurality of side wirings 200 may be disposed only on one side of the substrate 100 in the first direction DR1, but embodiments of the present disclosure are not limited thereto. For example, the plurality of side wirings 200 may also be disposed on the other side of the substrate 100 in the first direction DR1, on one side thereof in the second direction DR2, or on the other side thereof in the second direction DR2. In this case, the first pads PAD1 disposed on the first surface 100a of the substrate 100 may be additionally disposed on the other side in the first direction DR1, one side in the second direction DR2, or the other side in the second direction DR2, and the second pads PAD2 disposed on the second surface 100b of the substrate 100 may be additionally disposed on the other side in the first direction DR1, one side in the second direction DR2, or the other side in the second direction DR2. Hereinafter, for simplicity of description, a case where the plurality of side wirings 200 are disposed only on one side of the substrate 100 in the first direction DR1 will be mainly described.

The circuit boards CB may be disposed on the second surface 100b of the substrate 100. Each of the circuit boards CB may be connected to third pads PAD3 (refer to FIG. 9) disposed on the second surface 100b of the substrate 100 using a conductive adhesive member such as an anisotropic conductive film. As will be described later, the third pads PAD3 are electrically connected to the second pads PAD2, respectively, so that the circuit board CB may be electrically connected to the first pads PAD1 through the side wirings 200. The circuit boards CB may each be a flexible printed circuit board, a printed circuit board, or a flexible film such as a chip on film.

The display driving circuit DC may generate data voltages and provide them to the data lines extending from the pixels PX through the circuit board CB, the third pads PAD3, the second pads PAD2, the plurality of side wirings 200, and the first pads PAD1. The display driving circuit DC may be formed as an integrated circuit (IC) and attached onto the circuit board CB. Alternatively, the display driving circuit DC may be directly attached to the second surface 100b of the substrate 100 by a chip on glass (COG) method.

By connecting the first pads PAD1 disposed on the first surface 100a and the second pads PAD2 disposed on the second surface 100b using the plurality of side wirings 200 as described above, the flexible film bent along the side surface of the substrate 100 may be omitted and, thus, a bezel-less display device 10 with a reduced or minimized non-display area NDA may be realized.

Hereinafter, the structure of the pixel PX of the display device 10 according to one or more embodiments will be described.

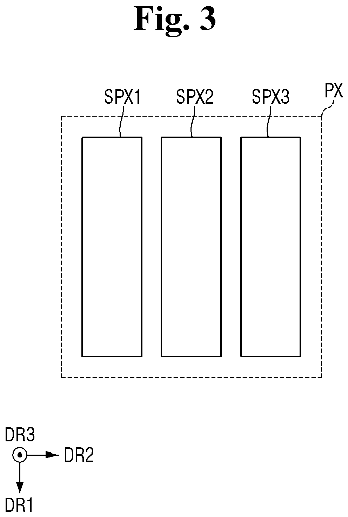

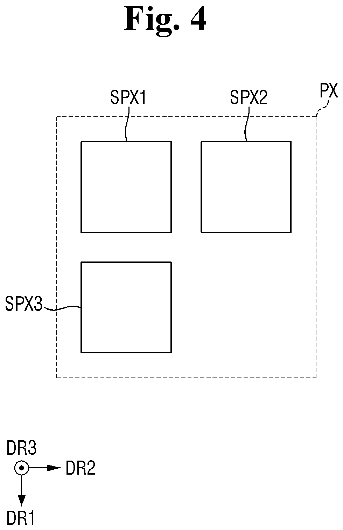

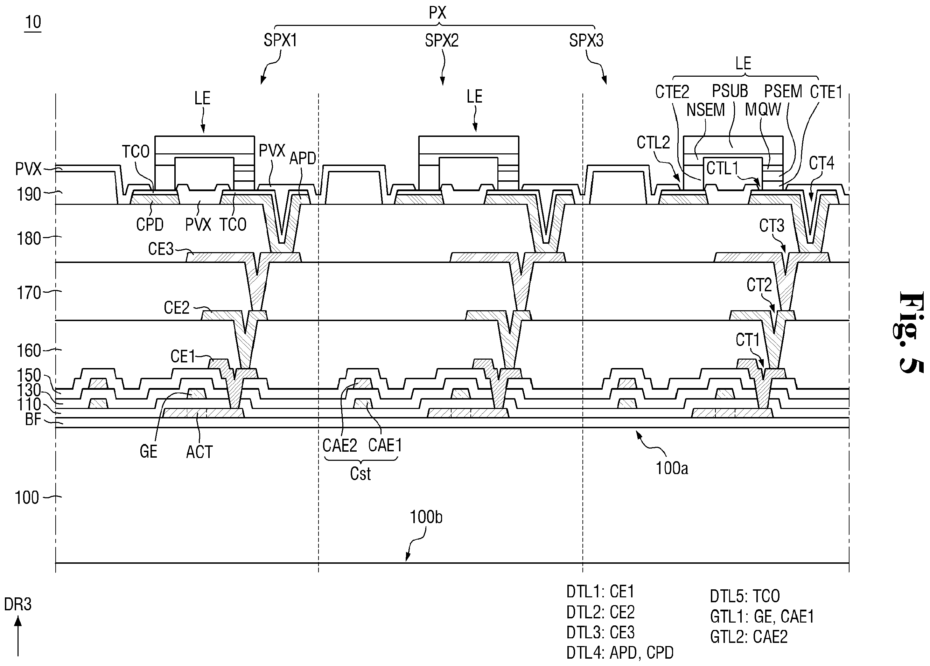

FIG. 3 is a diagram schematically illustrating a structure of a pixel of a display device according to one or more embodiments. FIG. 4 is a diagram schematically illustrating a structure of a pixel of a display device according to one or more embodiments. FIG. 5 is a structural diagram schematically illustrating another example of a cross-sectional structure of a pixel according to one or more embodiments.

Referring to FIGS. 3 and 4, each of the pixels PX may include a plurality of sub-pixels. Although FIGS. 3 and 4 illustrate that each of the pixels PX includes three sub-pixels SPX1, SPX2, and SPX3, i.e., a first sub-pixel SPX1, a second sub-pixel SPX2, and a third sub-pixel SPX3, the number of sub-pixels in embodiments is not limited thereto. Each of the first sub-pixel SPX1, the second sub-pixel SPX2, and the third sub-pixel SPX3 may be connected to any one of the data lines and at least one of scan lines.

Each of the first sub-pixel SPX1, the second sub-pixel SPX2, and the third sub-pixel SPX3 may have a rectangular, square, or rhombic planar shape. For example, each of the first sub-pixel SPX1, the second sub-pixel SPX2, and the third sub-pixel SPX3 may have a rectangular planar shape with long sides in the first direction DR1 and short sides in the second direction DR2 as shown in FIG. 3. Alternatively, each of the first sub-pixel SPX1, the second sub-pixel SPX2, and the third sub-pixel SPX3 may have a square or rhombic planar shape having sides of the same length in the first direction DR1 and the second direction DR2 as shown in FIG. 3.

The first sub-pixel SPX1, the second sub-pixel SPX2, and the third sub-pixel SPX3 may be arranged along the second direction DR2. Alternatively, any one of the second sub-pixel SPX2 and the third sub-pixel SPX3 and the first sub-pixel SPX1 may be arranged along the second direction DR2, and the other one of the second sub-pixel SPX2 and the third sub-pixel SPX3 and the first sub-pixel SPX1 may be arranged along the first direction DR1. For example, as shown in FIG. 4, the first sub-pixel SPX1 and the second sub-pixel SPX2 may be arranged along the second direction DR2, and the first sub-pixel SPX1 and the third sub-pixel SPX3 may be arranged along the first direction DR1.

The first sub-pixel SPX1 may emit a first light, the second sub-pixel SPX2 may emit a second light, and the third sub-pixel SPX3 may emit a third light. In this case, the first light may be light of a red wavelength band, the second light may be light of a green wavelength band, and the third light may be light of a blue wavelength band. Although the red wavelength band may be a wavelength band of about 600 nm to 750 nm, the green wavelength band may be a wavelength band of about 480 nm to 560 nm, and the blue wavelength band may be a wavelength band of about 370 nm to 460 nm, but the embodiments of the present disclosure are not limited thereto.

Each of the first sub-pixel SPX1, the second sub-pixel SPX2, and the third sub-pixel SPX3 may include an inorganic light emitting element having an inorganic semiconductor as a light emitting element LE (see FIG. 5) that emits light. For example, the inorganic light emitting element may be a flip chip type micro light emitting diode (LED), but is not limited thereto.

As shown in FIGS. 3 and 4, the area of the first sub-pixel SPX1, the area of the second sub-pixel SPX2, and the area of the third sub-pixel SPX3 may be substantially the same, but embodiments of the present disclosure are not limited thereto. For example, the area of the first sub-pixel SPX1, the area of the second sub-pixel SPX2, and the area of the third sub-pixel SPX3 may be different from each other.

Referring to FIG. 5, each of the plurality of sub-pixels SPX1, SPX2, and SPX3 constituting the pixel PX may include a plurality of conductive layers, a plurality of insulating layers, and a plurality of light emitting elements LE. The plurality of conductive layers and the plurality of insulating layers may form a transistor layer that transmits an electrical signal to the light emitting element LE.

The plurality of sub-pixels disposed on the substrate 100 may include, as the plurality of conductive layers, an active layer ACT, a first gate metal layer GTL1, a second gate metal layer GTL2, a first data metal layer DTL1, a second data metal layer DTL2, a third data metal layer DTL3, a fourth data metal layer DTL4, and a fifth data metal layer DTL5. Further, the plurality of pixels PX may include, as the plurality of insulating layers, a buffer layer BF, a gate insulating layer 110, a first interlayer insulating layer 130, a second interlayer insulating layer 150, and an upper via layer, and the upper via layer may include a first via layer 160, a second via layer 170, a third via layer 180, and a fourth via layer 190.

The substrate 100 serves as a base of the display device 10, and may be a base substrate or a base member for supporting the plurality of pixels PX. As described above, the substrate 100 may be a rigid substrate made of a glass material.

The buffer layer BF may be disposed on the top surface of the substrate 100, i.e., on the first surface 100a. The buffer layer BF may serve to prevent permeation of air or moisture into element layers constituting the pixel PX. The buffer layer BF may be formed of a plurality of inorganic layers that are alternately stacked. For example, the buffer layer BF may be formed of multiple layers in which one or more inorganic layers of a silicon nitride layer, a silicon oxynitride layer, a silicon oxide layer, a titanium oxide layer and an aluminum oxide layer are alternately stacked. In one or more embodiments, the buffer layer BF may be omitted.

The active layer ACT may be disposed on the buffer layer BF. The active layer ACT may include a silicon semiconductor such as polycrystalline silicon, monocrystalline silicon, low-temperature polycrystalline silicon, and amorphous silicon, or may include an oxide semiconductor.

The active layer ACT may include a channel region, a first region disposed on one side of the channel region, and a second region disposed on the other side of the channel region. The channel region of the active layer ACT may be a region overlapping a gate electrode GE to be described later in the third direction DR3. Each of the first region and the second region of the active layer ACT may be a region that does not overlap the gate electrode GE. The first region and the second region may be conductive regions obtained by doping a silicon semiconductor or an oxide semiconductor with ions.

The gate insulating layer 110 may be disposed on the active layer ACT and the buffer layer BF. The gate insulating layer 110 may be formed of an inorganic layer, for example, a silicon nitride layer, a silicon oxynitride layer, a silicon oxide layer, a titanium oxide layer, or an aluminum oxide layer.

The first gate metal layer GTL1 may be disposed on the gate insulating layer 110. The first gate metal layer GTL1 may include a gate electrode GE and a first capacitor electrode CAE1 of each sub-pixel. The gate electrode GE may form a thin film transistor for driving the pixel PX together with the active layer ACT. The first gate metal layer GTL1 may be formed as a single layer or multiple layers made of any one of molybdenum (Mo), aluminum (Al), chromium (Cr), gold (Au), titanium (Ti), nickel (Ni), neodymium (Nd) and copper (Cu) or an alloy thereof.

The first interlayer insulating layer 130 may be disposed on the first gate metal layer GTL1 and the gate insulating layer 110. The first interlayer insulating layer 130 may be formed of an inorganic layer, for example, a silicon nitride layer, a silicon oxynitride layer, a silicon oxide layer, a titanium oxide layer, or an aluminum oxide layer.

The second gate metal layer GTL2 may be disposed on the first interlayer insulating layer 130. The second gate metal layer GTL2 may include a second capacitor electrode CAE2. The second capacitor electrode CAE2 may overlap the first capacitor electrode CAE1 in the third direction DR3 to form a capacitor Cst. The second gate metal layer GTL2 may be formed as a single layer or multiple layers made of any one of molybdenum (Mo), aluminum (Al), chromium (Cr), gold (Au), titanium (Ti), nickel (Ni), neodymium (Nd) and copper (Cu) or an alloy thereof.

The second interlayer insulating layer 150 may be disposed on the second gate metal layer GTL2 and the first interlayer insulating layer 130. The second interlayer insulating layer 150 may be formed of an inorganic layer, for example, a silicon nitride layer, a silicon oxynitride layer, a silicon oxide layer, a titanium oxide layer, or an aluminum oxide layer.

The first data metal layer DTL1 including a first connection electrode CE1 and a data line may be disposed on the second interlayer insulating layer 150. The first data metal layer DTL1 may be formed as a single layer or multiple layers made of any one of molybdenum (Mo), aluminum (Al), chromium (Cr), gold (Au), titanium (Ti), nickel (Ni), neodymium (Nd) and copper (Cu) or an alloy thereof. In one or more embodiments, the first data metal layer DTL1 may have a two-layer structure of Ti/Al or a three-layer structure of Ti/Al/Ti.

The first connection electrode CE1 may be connected to the first region or the second region of the active layer ACT through a first contact hole CT1 penetrating the gate insulating layer 110, the first interlayer insulating layer 130, and the second interlayer insulating layer 150.

The first via layer 160 for flattening the stepped portion formed by the active layer ACT, the first gate metal layer GTL1, the second gate metal layer GTL2, and the first data metal layer DTL1 may be disposed on the first data metal layer DTL1 and the second interlayer insulating layer 150. The first via layer 160 may be formed of an organic layer such as acryl resin, epoxy resin, phenolic resin, polyamide resin, polyimide resin and the like.

The second data metal layer DTL2 may be disposed on the first via layer 160. The second data metal layer DTL2 may include a second connection electrode CE2. The second connection electrode CE2 may be connected to the first connection electrode CE1 through a second contact hole CT2 penetrating the first via layer 160. The second data metal layer DTL2 may be formed as a single layer or multiple layers made of any one of molybdenum (Mo), aluminum (Al), chromium (Cr), gold (Au), titanium (Ti), nickel (Ni), neodymium (Nd) and copper (Cu) or an alloy thereof. In one or more embodiments, the second data metal layer DTL2 may have a two-layer structure of Ti/Al or a three-layer structure of Ti/Al/Ti.

The second via layer 170 may be disposed on the second data metal layer DTL2 and the first via layer 160. The second via layer 170 may be formed of an organic layer such as acryl resin, epoxy resin, phenolic resin, polyamide resin, polyimide resin and the like.

The third data metal layer DTL3 may be disposed on the second via layer 170. The third data metal layer DTL3 may include a third connection electrode CE3. The third connection electrode CE3 may be connected to the second connection electrode CE2 through a third contact hole CT3 penetrating the second insulating layer and the second via layer 170. The third data metal layer DTL3 may be formed as a single layer or multiple layers made of any one of molybdenum (Mo), aluminum (Al), chromium (Cr), gold (Au), titanium (Ti), nickel (Ni), neodymium (Nd) and copper (Cu) or an alloy thereof. In one or more embodiments, the third data metal layer DTL3 may have a two-layer structure of Ti/Al or a three-layer structure of Ti/Al/Ti.

The third via layer 180 may be disposed on the third data metal layer DTL3 and second via layer 170. The third via layer 180 may be formed of an organic layer such as acryl resin, epoxy resin, phenolic resin, polyamide resin, polyimide resin and the like.

The fourth data metal layer DTL4 may be disposed on the third via layer 180. The fourth data metal layer DTL4 may include an anode pad electrode APD and a cathode pad electrode CPD. The anode pad electrode APD may be connected to the third connection electrode CE3 through a fourth contact hole CT4 penetrating the third via layer 180. The cathode pad electrode CPD may receive a first power voltage that is a low potential voltage. The fourth data metal layer DTL4 may be formed as a single layer or multiple layers made of any one of molybdenum (Mo), aluminum (Al), chromium (Cr), gold (Au), titanium (Ti), nickel (Ni), neodymium (Nd) and copper (Cu) or an alloy thereof. In one or more embodiments, the fourth data metal layer DTL4 may have a two-layer structure of Ti/Al or a three-layer structure of Ti/Al/Ti. Hereinafter, for simplicity of description, a case where the fourth data metal layer DTL4 has a three-layer structure of Ti/Al/Ti will be mainly described.

The fifth data metal layer DTL5 may be disposed on each of the anode pad electrode APD and the cathode pad electrode CPD. The fifth data metal layer DTL5 may include a transparent conductive layer for increasing an adhesive strength with the first contact electrode CTE1 and the second contact electrode CTE2 of the light emitting element LE. The fifth data metal layer DTL5 may be made of a transparent conductive oxide such as indium tin oxide (ITO) and indium zinc oxide (IZO).

The fourth via layer 190 may be further disposed on the third via layer 180. The fourth via layer 190 may be disposed in a space between the plurality of sub-pixels. In other words, the fourth via layer 190 may be disposed on a part of the third via layer 180 without being disposed on the entire third via layer 180. That is, the fourth via layer 190 may serve as a pixel defining layer for partitioning the sub-pixels. The fourth via layer 190 may be formed of an organic layer such as acryl resin, epoxy resin, phenolic resin, polyamide resin, polyimide resin and the like.

An upper passivation layer PVX may be disposed on the third via layer 180, the fifth data metal layer DTL5, and the fourth via layer 190. The upper passivation layer PVX may cover the edges of a transparent conductive layer TCO disposed on the anode pad electrode APD and a transparent conductive layer TCO disposed on the cathode pad electrode CPD, and may cover the top and side surfaces of the fourth via layer 190, and the top surface of the third via layer 180 exposed by the fourth via layer 190. The upper passivation layer PVX may be formed of an inorganic layer, e.g., a silicon nitride layer, a silicon oxynitride layer, a silicon oxide layer, a titanium oxide layer, or an aluminum oxide layer.

A first element contact hole CTL1 and a second element contact hole CTL2 exposing a part of the transparent conductive layer TCO disposed on the anode pad electrode APD and a part of the transparent conductive layer TCO disposed on the cathode pad electrode CPD may be formed in the upper passivation layer PVX. The first element contact hole CTL1 may expose a part of the transparent conductive layer TCO disposed on the anode pad electrode APD, and the second element contact hole CTL2 may expose a part of the transparent conductive layer TCO disposed on the cathode pad electrode CPD.

Each of the plurality of sub-pixels SPX1, SPX2, and SPX3 may include one light emitting element LE. The light emitting elements LE may be disposed on the transparent conductive layer TCO disposed on the anode pad electrode APD and the transparent conductive layer TCO disposed on the cathode pad electrode CPD that are respectively exposed by the first element contact hole CTL1 and the second element contact hole CTL2 formed in the upper passivation layer PVX. FIG. 5 illustrates that the light emitting element LE is a flip chip type micro LED in which the first contact electrode CTE1 and the second contact electrode CTE2 are disposed to oppose the anode pad electrode APD and the cathode pad electrode CPD, respectively, with the transparent conductive layer TCO interposed there between.

The light emitting element LE may be an inorganic light emitting element made of an inorganic material such as GaN. The light emitting element LE may have a length of several to several hundreds of µm in each of the first direction DR1, the second direction DR2, and the third direction DR3. For example, the light emitting element LE may have a length of about 100 µm or less in each of the first direction DR1, the second direction DR2, and the third direction DR3.

The light emitting elements LE may be formed by growing on a semiconductor substrate such as a silicon wafer. Each of the light emitting elements LE may be directly transferred from a silicon wafer onto the anode pad electrode APD and the cathode pad electrode CPD of the substrate 100. Alternatively, each of the light emitting elements LE may be transferred onto the anode pad electrode APD and the cathode pad electrode CPD of the substrate 100 through an electrostatic method using an electrostatic head or a stamping method using an elastic polymer material such as PDMS or silicon as a transfer substrate.

Each of the light emitting elements LE may be a light emitting structure including a base substrate PSUB, an n-type semiconductor NSEM, an active layer MQW, a p-type semiconductor PSEM, the first contact electrode CTE1, and the second contact electrode CTE2.

The base substrate PSUB of the light emitting element LE may be a sapphire substrate, but embodiments of the present disclosure are not limited thereto.

The n-type semiconductor NSEM of the light emitting element LE may be disposed on one surface of the base substrate PSUB. For example, the n-type semiconductor NSEM may be disposed on the bottom surface of the base substrate PSUB. The n-type semiconductor NSEM may be formed of GaN doped with an n-type conductive dopant such as Si, Ge, or Sn.

The active layer MQW of the light emitting element LE may be disposed on a part of one surface of the n-type semiconductor NSEM. The active layer MQW may include a material having a single or multiple quantum well structure. When the active layer MQW contains a material having a multiple quantum well structure, the active layer MQW may have the structure in which a plurality of well layers and barrier layers are alternately laminated. In this case, the well layer may be formed of InGaN, and the barrier layer may be formed of GaN or AlGaN, but embodiments of the present disclosure are not limited thereto.

Alternatively, the active layer MQW may have a structure in which semiconductor materials having large band gap energy and semiconductor materials having small band gap energy are alternately stacked, and may include Group III to V semiconductor materials according to the wavelength band of the emitted light.

The p-type semiconductor PSEM may be disposed on one surface of the active layer MQW. The p-type semiconductor PSEM may be formed of GaN doped with a p-type conductive dopant such as Mg, Zn, Ca, Se, or Ba.

The first contact electrode CTE1 may be disposed on the p-type semiconductor PSEM, and the second contact electrode CTE2 may be disposed on another part of one surface of the n-type semiconductor NSEM. The another part of one surface of the n-type semiconductor NSEM on which the second contact electrode CTE2 is disposed may be spaced from the part of one surface of the n-type semiconductor NSEM on which the active layer MQW is disposed.

The first contact electrode CTE1 and the anode pad electrode APD may be bonded to each other by a conductive adhesive member such as an anisotropic conductive film (ACF) or an anisotropic conductive paste (ACP). Alternatively, the first contact electrode CTE1 and the anode pad electrode APD may be bonded to each other by a soldering process.

Hereinafter, the arrangement relationship between the pixel PX and the side wiring 200 and the arrangement relationship between the side wiring 200 and the driver will be described.

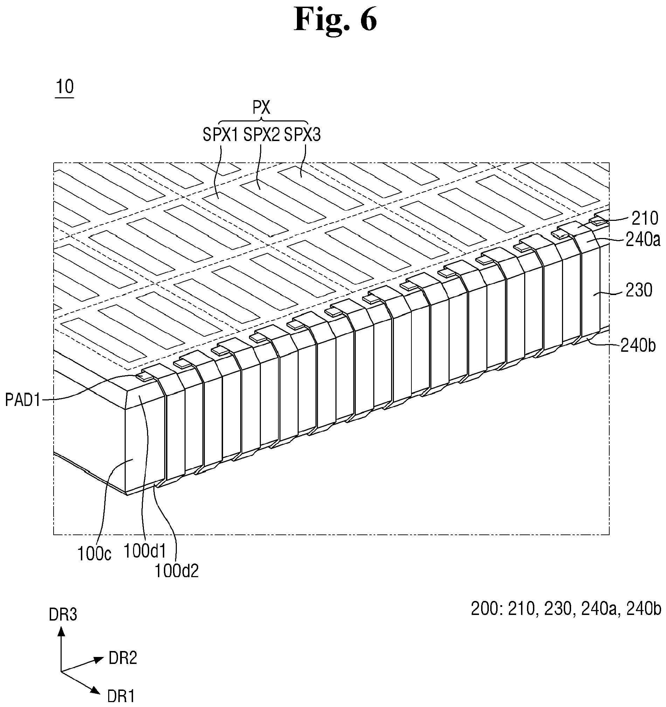

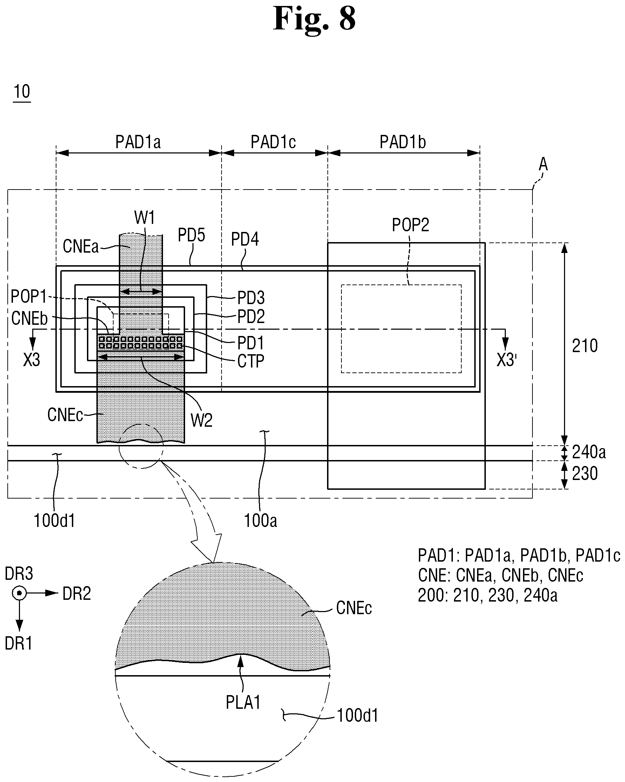

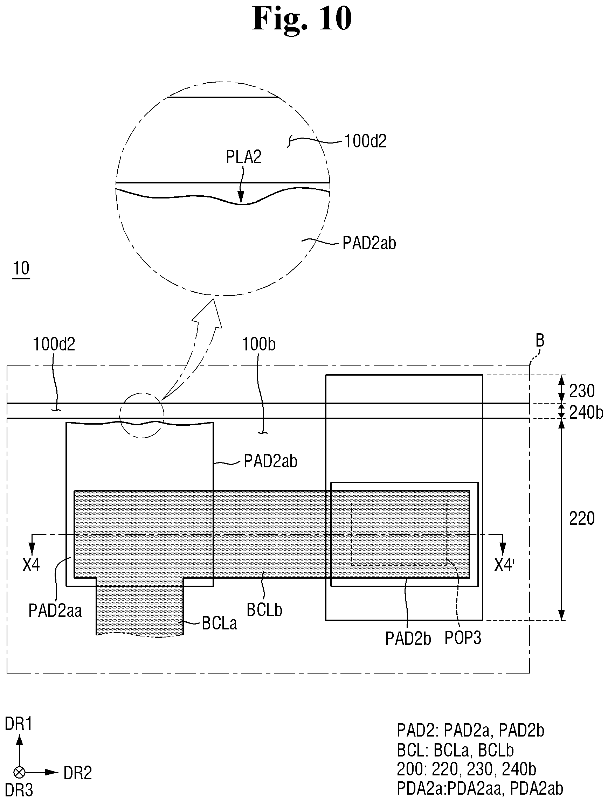

FIG. 6 is a perspective view illustrating the arrangement relationship between pixels and side wirings of a display device according to one or more embodiments. FIG. 7 is a plan view illustrating the arrangement relationship between pixels and side wirings of a display device according to one or more embodiments. FIG. 8 is an enlarged view of an area A of FIG. 7. FIG. 9 is a rear view illustrating the arrangement relationship between a driver and side wirings of a display device according to one or more embodiments. FIG. 10 is an enlarged view of an area B of FIG. 9.

Referring to FIGS. 6 to 10, the display device 10 further includes the plurality of first pads PAD1, the plurality of second pads PAD2, the plurality of third pads PAD3, and a plurality of bottom surface connection lines BCL.

Referring to FIGS. 7 and 8 in conjunction with FIG. 6, the plurality of first pads PAD1 may serve to transmit the electrical signal of the driver to each of the plurality of pixels PX. The first pads PAD1 may be disposed on the first surface 100a of the substrate 100. The first pads PAD1 may be disposed at one edge of the first surface 100a of the substrate 100 in the first direction DR1, i.e., in the pad area PDA. The pad area PDA, which is a part of the non-display area NDA, may refer to the non-display area NDA disposed at one edge of the display area DA in the first direction DR1. The first pads PAD1 may be arranged along the second direction DR2.

Each of the plurality of first pads PAD1 may have a shape extending in the second direction DR2. The side wiring 200 may expose a part of each of the plurality of first pads PAD1. In other words, the width of the side wiring 200 in the second direction DR2 may be smaller than the width of each of the plurality of first pads PAD1 in the second direction DR2. In one or more embodiments, a part of the first pad PAD1 may be exposed while protruding from the side wiring 200 toward one side in the second direction DR2, but embodiments of the present disclosure are not limited thereto. For example, a part of the first pad PAD1 may be exposed while protruding from the side wiring 200 toward the other side in the second direction DR2.

The first pad PAD1 may include a first region PAD1a that does not overlap the side wiring 200 in the third direction DR3, a second region PAD1b that overlaps the side wiring 200 in the third direction DR3, and a third region PAD1c that connects the first region PAD1a and the second region PAD1b.

The first pad PAD1 may include a first upper pad electrode PD1, a second upper pad electrode PD2, a third upper pad electrode PD3, a fourth upper pad electrode PD4, and a fifth upper pad electrode PD5. The planar area of the second upper pad electrode PD2 is greater than that of the first upper pad electrode PD1, the planar area of the third upper pad electrode PD3 may be greater than that of the second upper pad electrode PD2, the planar area of the fourth upper pad electrode PD4 is greater than that of the third upper pad electrode PD3, and the planar area of the fifth upper pad electrode PD5 may be greater than that of the fourth upper pad electrode PD4. In one or more embodiments, the first upper pad electrode PD1, the second upper pad electrode PD2, the third upper pad electrode PD3, the fourth upper pad electrode PD4, and the fifth upper pad electrode PD5 may have a rectangular planar shape, but embodiments of the present disclosure are not limited thereto.

In one or more embodiments, the first upper pad electrode PD1, the second upper pad electrode PD2, the third upper pad electrode PD3, the fourth upper pad electrode PD4, and the fifth upper pad electrode PD5 may be disposed in the first region PAD1a of the first pad PAD1, and the first upper pad electrode PD1, the second upper pad electrode PD2, and the third upper pad electrode PD3 may not be disposed in the second region PAD1b and the third region PAD1c of the first pad PAD1. For example, the fourth upper pad electrode PD4 and the fifth upper pad electrode PD5 may extend in the second direction DR2 to form the second region PAD1b and the third region PAD1c of the first pad PAD1, and the first upper pad electrode PD1, the second upper pad electrode PD2, and the third upper pad electrode PD3 may be disposed only in the first region PAD1a of the first pad PAD1, but embodiments of the present disclosure are not limited thereto.

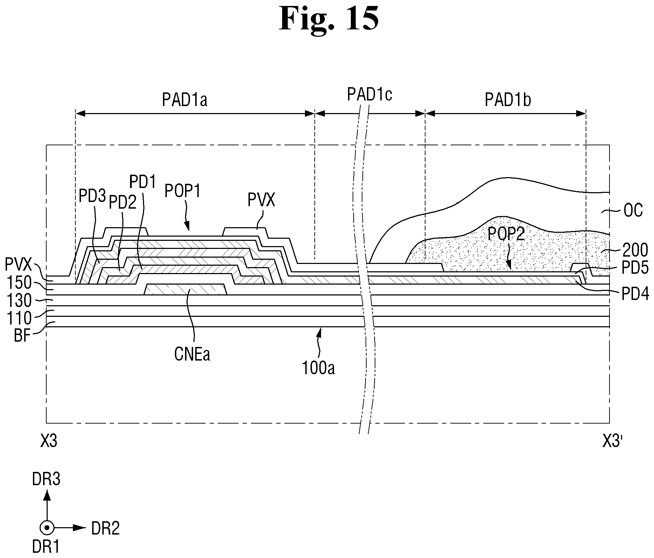

A first pad opening POP1 where an inspection device for checking whether or not the first pad PAD1 and the side wiring 200 are electrically connected may be connected may be formed in the first region PAD1a of the first pad PAD1, and a second pad opening POP2 in contact with the side wiring 200 may be formed in the second region PAD1b thereof. Because the third region PAD1c of the first pad PAD1 electrically connects the first region PAD1a and the second region PAD1b (refer to FIG. 15), it is possible to check whether or not the first pad PAD1 and the side wiring 200 are electrically connected using the inspection device.

A top surface connection line CNE overlaps the first region PAD1a of the first pad PAD1 in the third direction DR3, and does not overlap the second region PAD1b and the third region PAD1c thereof in the third direction DR3. The top surface connection line CNE may include a first contact portion CNEb in contact with the first region PAD1a of the first pad PAD1, a first peeling portion CNEc extending from the first contact portion CNEb toward one side in the first direction DR1, and a first line portion CNEa extending from the first contact portion CNEb toward the other side in the first direction DR1.

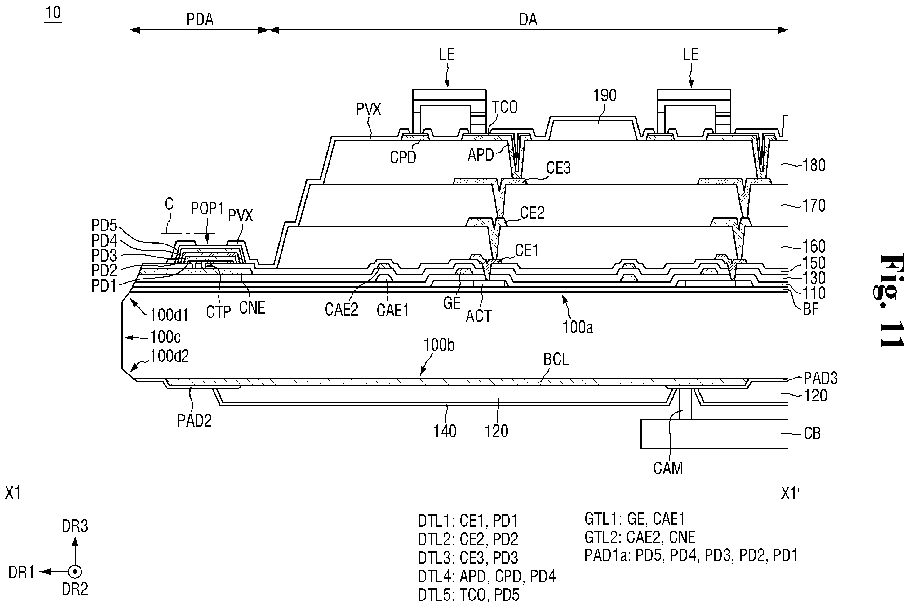

As shown in FIG. 11, the first contact portion CNEb of the top surface connection line CNE may be electrically connected to the first upper pad electrode PD1 through a pad contact hole CTP penetrating the second interlayer insulating layer 150. In one or more embodiments, the pad contact hole CTP may be biased to one side of the first upper pad electrode PD1 in the first direction DR1, but embodiments of the present disclosure are not limited thereto.

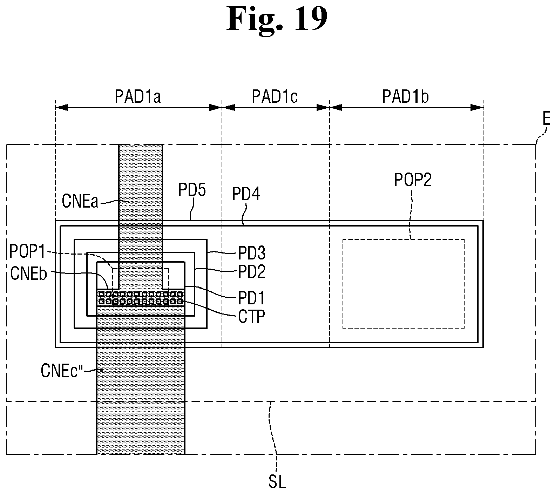

The first peeling portion CNEc of the top surface connection line CNE may be a pattern extending from one side of the first contact portion CNEb in the first direction DR1 toward the first chamfered surface 100d1, i.e., extending in the first direction DR1 toward one side in the first direction DR1. At one end of the first peeling portion CNEc in the first direction DR1, an irregular first peeling pattern PLA1 may be formed as a result of the step of forming the first chamfered surface 100d1 in a display device manufacturing method to be described later. In other words, the first peeling pattern PLA1, which is a pattern formed when a part of an inspection line CNEc" (see FIG. 19) for inspecting electrical connection between the top surface connection line CNE and various elements disposed on the first surface 100a of the substrate 100 is torn off, may have an irregular shape. A detailed description thereof will be given later. FIG. 8 illustrates that the first peeling pattern PLA1 has a wave shape having a plurality of irregularities, but the shape of the first peeling pattern PLA1 in embodiments is not limited thereto.

If the side wiring 200 is disposed on the first region PAD1a of the first pad PAD1 and overlaps the first peeling portion CNEc, the side wiring 200 is disconnected by the first peeling portion CNEc, or the contact between the side wiring 200 and the first pad PAD1 becomes poor, which may increase the resistance value between the side wiring 200 and the first pad PAD1. Therefore, the side wiring 200 is disposed in the second region PAD1b of the first pad PAD1 to prevent overlapping of the first peeling portion CNEc and the side wiring 200.

The first line portion CNEa of the top surface connection line CNE may have a pattern that protrudes from the other side of the first contact portion CNEb in the first direction DR1 and extends toward the other side in the first direction DR1. The first line portion CNEa may transmit the electrical signal received from the side wiring 200 to the plurality of pixels PX. In one or more embodiments, the first line portion CNEa may extend to the display area DA over the pad area PDA to be electrically connected to the plurality of pixels PX, but embodiments of the present disclosure are not limited thereto. For example, the first line portion CNEa may be in contact with a separate element layer to transmit an electrical signal to the plurality of pixels PX through the element layer.

A width W2 of the first contact portion CNEb in the second direction DR2 may be greater than a width W1 of the first line portion CNEa in the second direction DR2. This may be to widen a contact area with the first upper pad electrode PD1.

Referring to FIGS. 9 and 10 in conjunction with FIG. 6, the plurality of second pads PAD2 may serve to transmit the electrical signal of the driver to the first pads PAD1 through the side wiring 200. The second pads PAD2 may be disposed on the second surface 100b of the substrate 100. The second pads PAD2 may be disposed at one edge of the second surface 100b of the substrate 100 in the first direction DR1. The second pads PAD2 may be arranged along the second direction DR2. The second pads PAD2 may be connected to the driver by the bottom surface connection lines BCL.

A first portion PAD2a may be disposed on the bottom surface connection line BCL to be electrically connected to the bottom surface connection line BCL. Accordingly, the first portion PAD2a may transmit the signal applied from the driver from the bottom surface connection line BCL to the side wiring 200. The first portion PAD2a may provide a region where an inspection device for checking whether or not the second pad PAD2 is electrically connected to the side wiring 200 may be connected.

The first portion PAD2a may include a second contact portion PAD2aa covering the bottom surface connection line BCL and a second peeling portion PAD2ab protruding from one side of the second contact portion PAD2aa in the first direction DR1 and extending toward the second chamfered surface 100d2, i.e., extending in the first direction DR1 toward one side in the first direction DR1.

The second contact portion PAD2aa may be electrically connected to a pad electrode portion BCLb of the bottom surface connection line BCL as shown in FIG. 10.

At one end of the second peeling portion PAD2ab in the first direction DR1, an irregular second peeling pattern PLA2 may be formed as a result of the step of forming the second chamfered surface 100d2 in a display device manufacturing method to be described later. In other words, the second peeling pattern PLA2, which is a pattern formed when a part of an inspection line for inspecting electrical connection between the bottom surface connection line BCL and various elements disposed on the second surface 100b of the substrate 100 is torn off, may have an irregular shape. FIG. 10 illustrates that the second peeling pattern PLA2 has a wave shape having a plurality of irregularities, but the shape of the second peeling pattern PLA2 in embodiments is not limited thereto.

If the side wiring 200 is disposed on the first portion PAD2a of the second pad PAD2 and overlaps the second peeling portion PAD2ab, the side wiring 200 is disconnected by the second peeling portion PAD2ab, or the contact between the side wiring 200 and the second pad PAD2 becomes poor, which may increase the resistance value between the side wiring 200 and the second pad PAD2. Therefore, the side wiring 200 is disposed at the second portion PAD2b of the second pad PAD2 to prevent overlapping of the second peeling portion PAD2ab and the side wiring 200.

The second portion PAD2b of the second pad PAD2 may be in contact with and electrically connected to the side wiring 200. Specifically, a third pad opening POP3 to be electrically connected to the side wiring 200 may be formed at the second portion PAD2b of the second pad PAD2. The second pad PAD2 may be in contact with and electrically connected to the side wiring 200 through the third pad opening POP3. Accordingly, the second pad PAD2 may transmit the electrical signal applied from the driver to the side wiring 200.

The bottom surface connection line BCL may serve to connect the second pads PAD2 and the third pads PAD3 to be described later. The bottom surface connection line BCL may be disposed on the second surface 100b of the substrate. The bottom surface connection line BCL may include a line portion BCLa connected to the driver and a pad electrode portion BCLb covered by the second pad PAD2.

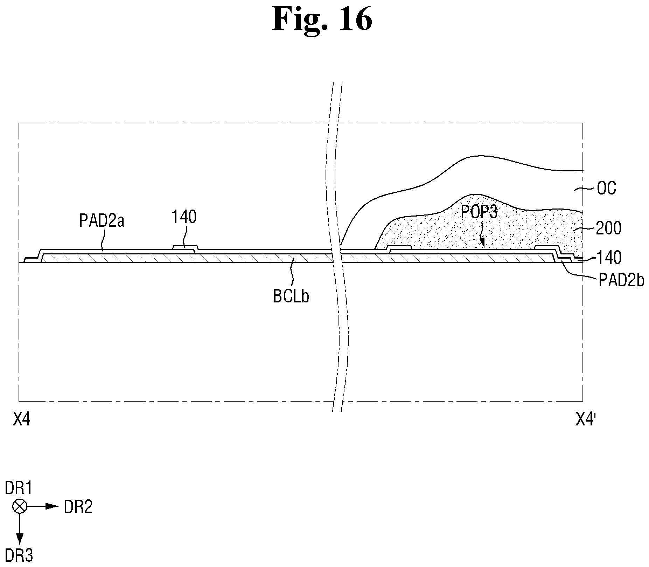

The pad electrode portion BCLb of the bottom surface connection line BCL, which is a portion overlapping each of the first portion PAD2a and the second portion PAD2b of the second pad PAD2 to be described later, may be a portion electrically connected to the second pad PAD2 (see FIG. 16). The pad electrode portion BCLb may electrically connect the first portion PAD2a and the second portion PAD2b of the second pad PAD2 as shown in FIG. 16. In one or more embodiments, the pad electrode portion BCLb may have a rectangular planar shape with long sides in the second direction DR2 and short sides in the first direction DR1, but the present disclosure is not limited thereto.

The line portion BCLa of the bottom surface connection line BCL may be a portion protruding from the other side of the pad electrode portion BCLb in the first direction DR1 and extending in a direction toward the driver, i.e., extending in the first direction DR1 toward the other side in the first direction DR1. The line portion BCLa may be electrically connected to the driver to transmit the electrical signal applied from the driver. In one or more embodiments, the line portion BCLa and the pad electrode portion BCLb may be integrally formed, but embodiments of the present disclosure are not limited thereto.

Referring to FIGS. 9 and 10 in conjunction with FIG. 6, the plurality of third pads PAD3 may serve to transmit the electrical signal generated from the driver to the second pads PAD2 through the bottom surface connection line BCL. The third pads PAD3 may be disposed on the second surface 100b of the substrate 100. The third pads PAD3 may be disposed to be adjacent to the center of the second surface 100b of the substrate 100 compared to the second pads PAD2. The third pads PAD3 may be arranged along the second direction DR2. The third pads PAD3 may be arranged to correspond to terminals formed at the driver. In other words, the third pads PAD3 may be arranged to correspond to the terminals formed on the circuit board CB of the driver. In order to connect a larger number of third pads PAD3 to the circuit board CB, the gap between the third pads PAD3 adjacent to each other in the second direction DR2 may be smaller than the gap between the second pads PAD2 adjacent to each other in the second direction DR2.

Because the gap between the second pads PAD2 adjacent to each other in the first direction DR1 and the gap between the third pads PAD3 adjacent to each other in the first direction DR1 are different, the bottom surface connection line BCL may be bent at least once. The bottom surface connection line BCL may be integrally formed with the second pad PAD2 and the third pad PAD3. The second pad PAD2, the third pad PAD3, and the bottom surface connection line BCL may be formed as a single layer or multiple layers made of any one of molybdenum (Mo), aluminum (Al), chromium (Cr), gold (Au), titanium (Ti), nickel (Ni), neodymium (Nd), and copper (Cu) or an alloy thereof.

Referring back to FIGS. 6 to 10, the side wiring 200 may include a first flat portion 210, a first inclined portion 240a, a connection portion 230, a second inclined portion 240b, and a second flat portion 220.

The first flat portion 210 of the side wiring 200 may be a portion disposed on the first surface 100a of the substrate 100, specifically, in the pad area PDA of the first surface 100a. The first flat portion 210 may be disposed on the first pad PAD1, and may be disposed to cover a part of the first pad PAD1. The first flat portion 210 may be electrically connected to the first pad PAD1. As described above, the first pad PAD1 may protrude from the first flat portion 210 of the side wiring 200 in the second direction DR2.

The first inclined portion 240a of the side wiring 200 may be a portion disposed on the first chamfered surface 100d1 of the substrate 100. The first inclined portion 240a may form a slope along a direction in which the first chamfering surface 100d1 is inclined. The first inclined portion 240a may be disposed between the first flat portion 210 and the connection portion 230.

The connection portion 230 of the side wiring 200 may be a portion disposed on the first side surface 100c of the substrate 100. The connection portion 230 may be disposed between the first inclined portion 240a and the second inclined portion 240b.

The second inclined portion 240b of the side wiring 200 may be a portion disposed on the second chamfered surface 100d2 of the substrate 100. The second inclined portion 240b may form a slope along a direction in which the second chamfering surface 100d2 is inclined. The second inclined portion 240b may be disposed between the second flat portion 220 and the connection portion 230.

The second flat portion 220 of the side wiring 200 may be a portion disposed on the second surface 100b of the substrate 100. The second flat portion 220 may be disposed on the second pad PAD2, and may be disposed to cover a part of the second pad PAD2. The second flat portion 220 may be electrically connected to the second pad PAD2. As described above, the second pad PAD2 may protrude from the second flat portion 220 of the side wiring 200 in the second direction DR2. A description thereof will be given later.

The side wiring 200 may include a metal powder containing metal particles such as silver (Ag) and copper (Cu) and a polymer such as an acrylic resin or an epoxy resin. The metal powder may allow the side wiring 200 to have conductivity, and the polymer may serve as a binder connecting the metal particles. Hereinafter, for simplicity of description, a case where the side wiring 200 contains silver (Ag) will be mainly described.

The side wiring 200 may be formed by printing a metal paste containing metal particles, a monomer, and a solution on the substrate 100 using a silicon pad and then performing sintering using a laser. The metal particles are in close contact with each other and aggregated while the monomer reacts with the polymer by the heat generated by the laser in the sintering process, so that the specific resistance of the side wiring 200 may be lowered.

Hereinafter, the stacked structure of the above-described components will be described.

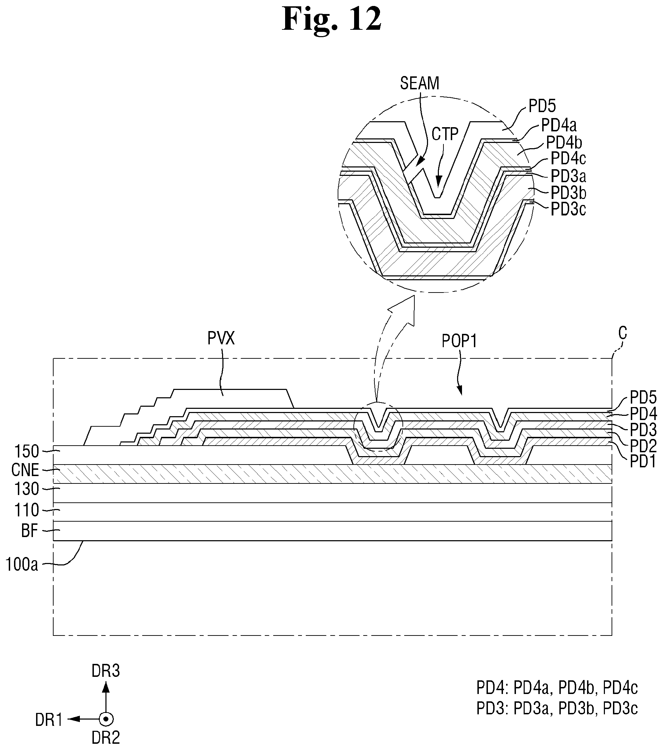

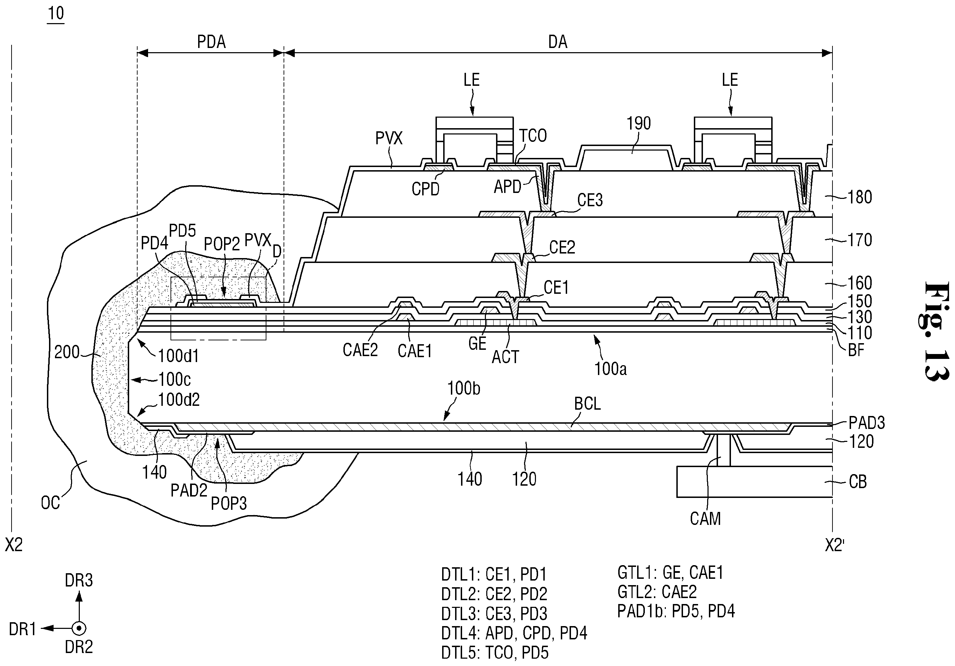

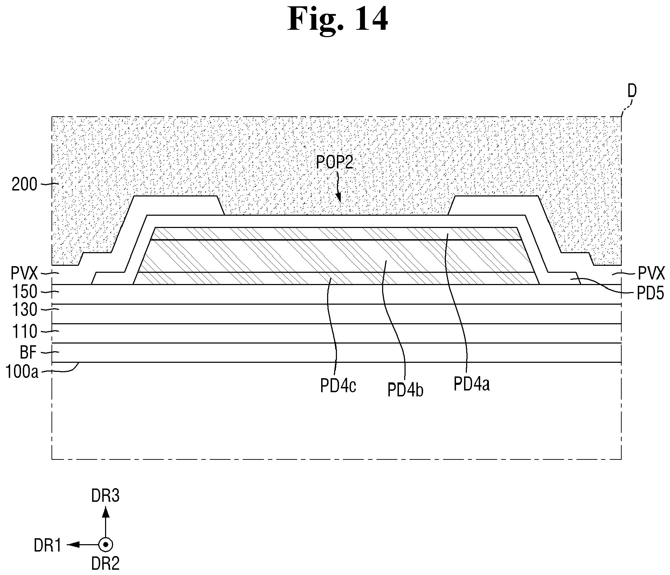

FIG. 11 is a cross-sectional view illustrating a cross section taken along the line X1-X1' of FIGS. 7 and 9. FIG. 12 is an enlarged view of an area C of FIG. 11. FIG. 13 is a cross-sectional view illustrating a cross section taken along the line X2-X2' of FIGS. 7 and 9. FIG. 14 is an enlarged view of an area D of FIG. 13.

Referring to FIGS. 11 to 14, the first pad PAD1 may be disposed adjacent to the pixel PX disposed at the outermost part while being spaced therefrom, and the second pad PAD2 may be disposed on the second surface 100b of the substrate 100.

For simplicity of description, from among the plurality of sub-pixels disposed in the display area DA, the sub-pixel disposed closest to the pad area PDA will be referred to as 'outermost pixel'. The outermost pixel is a sub-pixel disposed at one edge of the display area DA in the first direction DR1, and the sub-pixel adjacent to the outermost pixel is disposed only on the other side of the outermost pixel in the first direction DR1 and is not disposed on one side of the outermost pixel in the first direction DR1. Accordingly, the fourth via layer 190 may not be disposed on one side of the outermost pixel in the first direction DR1, and the fourth via layer 190 may be disposed on the other side in the first direction DR1.

Because the structure of the outermost pixel is the same as that of the sub-pixel described in FIG. 5, the description thereof will be omitted.

In the pad area PDA, the first data metal layer DTL1 may further include the first upper pad electrode PD1, the second data metal layer DTL2 may further includes the second upper pad electrode PD2, the third data metal layer DTL3 may further includes the third upper pad electrode PD3, the fourth data metal layer DTL4 may further include the fourth upper pad electrode PD4, and the fifth data metal layer DTL5 may further include the fifth upper pad electrode PD5.

The first pad PAD1 may include the first upper pad electrode PD1, the second upper pad electrode PD2, the third upper pad electrode PD3, the fourth upper pad electrode PD4, and the fifth upper pad electrode PD5. The second upper pad electrode PD2 may be disposed on the first upper pad electrode PD1, the third upper pad electrode PD3 may be disposed on the second upper pad electrode PD2, the fourth upper pad electrode PD4 may be disposed on the third upper pad electrode PD3, and the fifth upper pad electrode PD5 may be disposed on the fourth upper pad electrode PD4. The top surface of the first upper pad electrode PD1 may be in direct contact with the bottom surface of the second upper pad electrode PD2, the top surface of the second upper pad electrode PD2 may be in direct contact with the bottom surface of the third upper pad electrode PD3, the top surface of the third upper pad electrode PD3 may be in direct contact with the bottom surface of the fourth upper pad electrode PD4, and the top surface of the fourth upper pad electrode PD4 may be in direct contact with the bottom surface of the fifth upper pad electrode PD5.

The second upper pad electrode PD2 may be disposed on the first upper pad electrode PD1 to completely cover the top and side surfaces of the first upper pad electrode PD1, the third upper pad electrode PD3 may be disposed on the second upper pad electrode PD2 to completely cover the top and side surfaces of the second upper pad electrode PD2, the fourth upper pad electrode PD4 may be disposed on the third upper pad electrode PD3 to completely cover the top and side surfaces of the third upper pad electrode PD3, and the fifth upper pad electrode PD5 may be disposed on the fourth upper pad electrode PD4 to completely cover the top and side surfaces of the fourth upper pad electrode PD4.

In other words, as shown in FIG. 8, the planar area of the fifth upper pad electrode PD5 may be greater than that of the fourth upper pad electrode PD4, the planar area of the fourth upper pad electrode PD4 may be greater than that of the third upper pad electrode PD3, the planar area of the third upper pad electrode PD3 may be greater than that of the second upper pad electrode PD2, and the planar area of the second upper pad electrode PD2 may be greater than that of the first upper pad electrode PD1.

The first upper pad electrode PD1 of the first pad PAD1 may be disposed on the second interlayer insulating layer 150. The first upper pad electrode PD1 may be electrically connected to the top surface connection line CNE disposed on the first interlayer insulating layer 130 through the pad contact hole CTP penetrating the second interlayer insulating layer 150. The top surface connection line CNE may be electrically connected to the above-described data line.

The bottom surface connection line BCL may be disposed on the second surface 100b of the substrate 100 to extend in the first direction DR1. The bottom surface connection line BCL may be formed as a single layer or multiple layers made of any one of molybdenum (Mo), aluminum (Al), chromium (Cr), gold (Au), titanium (Ti), nickel (Ni), neodymium (Nd), and copper (Cu) or an alloy thereof.

The second pad PAD2 may be disposed on the second surface 100b of the substrate 100. The second pad PAD2 may be disposed on one side of the bottom surface connection line BCL in the first direction DR1, and the third pad PAD3 may be disposed on the other side of the bottom surface connection line BCL in the first direction DR1. In one or more embodiments, the second pad PAD2 and the third pad PAD3 may be formed of a transparent conductive oxide such as indium tin oxide (ITO) and indium zinc oxide (IZO), but embodiments of the disclosure are not limited thereto. For example, the second pad PAD2 and the third pad PAD3 may be formed as a single layer or multiple layers made of any one of molybdenum (Mo), aluminum (Al), chromium (Cr), gold (Au), titanium (Ti), nickel (Ni), neodymium (Nd) and copper (Cu) or an alloy thereof.

A lower via layer 120 may be disposed on the second surface 100b of the substrate 100. Specifically, the lower via layer 120 may be disposed on the other surface of the bottom surface connection line BCL in the third direction DR3. The lower via layer 120 may partially cover the second pad PAD2 and the third pad PAD3, and may expose at least a part of the second pad PAD2 and at least a part of the third pad PAD3. The portion of the second pad PAD2 exposed by the lower via layer 120 may be in direct contact with and electrically connected to the second flat portion 220 of the side wiring 200, and the portion of the third pad PAD3 exposed by the lower via layer 120 may be electrically connected to the circuit board CB by a conductive adhesive member CAM. The conductive adhesive member CAM may be an anisotropic conductive film or an anisotropic conductive paste.

The lower via layer 120 may be formed of an organic layer such as acryl resin, epoxy resin, phenolic resin, polyamide resin, polyimide resin and the like.

The lower passivation layer 140 may cover the lower via layer 120. Specifically, the lower passivation layer 140 may be disposed on the lower via layer 120, and may not be disposed on the second pad PAD2 and the third pad PAD3. In other words, each of the second pad PAD2 and the third pad PAD3 may include a portion exposed by the lower passivation layer 140. The lower passivation layer 140 may be formed of an inorganic layer, e.g., a silicon nitride layer, a silicon oxynitride layer, a silicon oxide layer, a titanium oxide layer, or an aluminum oxide layer. As shown in FIG. 13 (and FIG. 10), the lower passivation layer may form the third pad opening POP3 exposing the second portion PAD2b of the second pad PAD2.

The side wiring 200 may be disposed on the first surface 100a, the first chamfered surface 100d1, the first side surface 100c, the second chamfered surface 100d2, and the second surface 100b of the substrate 100. The side wiring 200 may be disposed on the first pad PAD1 disposed at one edge of the first surface 100a of the substrate 100 in the first direction DR1 to be electrically connected to the first pad PAD1. The side wiring 200 may be disposed on the second pad PAD2 disposed at one edge of the second surface 100b of the substrate 100 in the first direction DR1 to be connected to the second pad PAD2. The side wiring 200 may be in contact with the first chamfered surface 100d1, the first side surface 100c, and the second chamfered surface 100d2 of the substrate 100.

An overcoat layer OC may be disposed on the first surface 100a, the first chamfered surface 100d1, the first side surface 100c, the second chamfered surface 100d2, and the second surface 100b of the substrate 100. The overcoat layer OC may be disposed to cover the side wiring 200. The overcoat layer OC may be formed of an organic layer such as acryl resin, epoxy resin, phenolic resin, polyamide resin, polyimide resin and the like.

In one or more embodiments, the first via layer 160, the second via layer 170, and the third via layer 180 extending in the display area DA in the first direction DR1 may no longer extend near the boundary of the display area DA and the pad area PDA.

The upper passivation layer PVX may form the first pad opening POP1 exposing the top surface of the fifth upper pad electrode PD5 in the first region PAD1a of the first pad PAD1 as shown in FIG. 11 (and FIG. 8), and may form the second pad opening POP2 exposing the top surface of the fifth upper pad electrode PD5 in the second region PAD1b of the first pad PAD1 as shown in FIG. 13 (and FIG. 8). The side wiring 200 may be electrically connected to the first pad PAD1 through the second pad opening POP2.

As described above, the first upper pad electrode PD1, the second upper pad electrode PD2, the third upper pad electrode PD3, the fourth upper pad electrode PD4, and the fifth upper pad electrode PD5 may be disposed in the first region PAD1a of the first pad PAD1, and the first upper pad electrode PD1, the second upper pad electrode PD2, and the third upper pad electrode PD3 may not be disposed in the second region PAD1b and the third region PAD1c of the first pad PAD1.

Referring to FIGS. 11 and 12, the pad contact hole CTP for contact with the top surface connection line CNE disposed under the first pad PAD1 may be formed in the first region PAD1a of the first pad PAD1. The pad contact hole CTP has a shape penetrating the second interlayer insulating layer 150 disposed between the top surface connection line CNE and the first pad PAD1.

The first upper pad electrode PD1, the second upper pad electrode PD2, the third upper pad electrode PD3, and the fourth upper pad electrode PD4, and the fifth upper pad electrode PD5 constituting the first region PAD1a of the first pad PAD1 are stacked with substantially the same thickness along the planar profile of the second interlayer insulating layer 150, so that they may be bent at least at a portion where the pad contact hole CTP penetrating the second interlayer insulating layer 150 is formed to form a fault. Because the first upper pad electrode PD1, the second upper pad electrode PD2, the third upper pad electrode PD3, the fourth upper pad electrode PD4, and the fifth upper pad electrode PD5 are sequentially stacked in the first region PAD1a where the pad contact hole CTP is formed, the regions corresponding to the first upper pad electrode PD1, the second upper pad electrode PD2, the third upper pad electrode PD3, the fourth upper pad electrode PD4, and the fifth upper pad electrode PD5 are not etched, which makes it possible to prevent the top surface connection line CNE disposed under the first region PAD1a from being etched.

As described above, each of the first upper pad electrode PD1, the second upper pad electrode PD2, the third upper pad electrode PD3, and the fourth upper pad electrode PD4 may be formed as multiple layers, and may have a three-layer structure of Ti/Al/Ti, for example. When each of the first upper pad electrode PD1, the second upper pad electrode PD2, the third upper pad electrode PD3, and the fourth upper pad electrode PD4 has a three-layer structure of Ti/Al/Ti, an aluminum (Al) layer may be disposed between titanium (Ti) layers and prevented from being corroded by exposure to the outside due to the titanium layers. However, when the pad electrodes are stacked while being bent at a portion where the pad contact hole CTP is formed, the titanium layers covering the aluminum layer may not be properly deposited, so that the aluminum layer may be exposed to the outside.

For example, the fourth upper pad electrode PD4 may include a first layer PD4a containing titanium, a second layer PD4b disposed under the first layer PD4a and containing aluminum, and a third layer PD4c disposed under the second layer PD4b and containing titanium, and the third upper pad electrode PD3 may include a first layer PD3a disposed under the third layer PD4c of the fourth upper pad electrode pad PD4 and containing titanium, a second layer PD3b disposed under the first layer PD3a and containing aluminum, and a third layer PD3c disposed under the second layer PAD3b and containing titanium. The profiles of the first layer PD4a of the fourth upper pad electrode PD4 and the fifth upper pad electrode PD5 are bent near the pad contact hole CTP to form a fault. Therefore, when the first layer PD4a of the fourth upper pad electrode PD4 and the fifth upper pad electrode PD5 are deposited near the pad contact hole CTP, they may not be completely deposited and may include an exposure hole SEAM exposing the layer disposed thereunder, i.e., the second layer PD4b of the fourth upper pad electrode PD4. In other words, the second layer PD4b of the fourth upper pad electrode PD4 may be exposed to the outside by the exposure hole SEAM.

If the side wiring 200 is disposed in the first region PAD1a of the first pad PAD1, a portion of the second layer PD4b of the fourth upper pad electrode PD4 that is exposed to the outside by the exposure hole SEAM may be in direct contact with the side wiring 200. In this case, the standard reduction potential values of the side wiring 200 and the second layer PD4b of the fourth upper pad electrode PD4 are different, so that a current flows due to a potential difference generated between the side wiring 200 and the second layer PD4b of the fourth upper pad electrode PD4. As a result, galvanic corrosion in which corrosion of a metal having a relatively small standard reduction potential value is promoted may occur. Specifically, because the second layer PD4b of the fourth pad electrode PD4 contains aluminum (Al) and the side wiring 200 contains silver (Ag) as described above, the corrosion of the second layer PD4b of the fourth pad electrode PD4 containing aluminum (Al) having a relatively small standard reduction potential value may be promoted. Accordingly, the contact between the side wiring 200 and the first pad PAD1 may become poor.

Hence, the side wiring 200 is disposed on the second region PAD1b of the first pad PAD1 in order to prevent direct contact between the portion of the second layer PD4b of the fourth upper pad electrode PD4 exposed to the outside by the exposure hole SEAM and the side wiring 200.

Referring to FIGS. 13 and 14, the fourth upper pad electrode PD4 and the fifth upper pad electrode PD5 are disposed in the second region PAD1b of the first pad PAD1, and the top surface connection line CNE is not disposed under the second region PAD1b of the first pad PAD1. In other words, because the top surface connection line CNE is not disposed in the second region PAD1b of the first pad PAD1, the above-described first peeling portion CNEc is not disposed and the pad contact hole CTP for contact with the top surface connection line CNE is not formed. Therefore, the profile of the fourth upper pad electrode PD4 and the fifth upper pad electrode PD5 may have an overall flat structure without a stepped portion.

Specifically, the third layer PD4c of the fourth upper pad electrode PD4 may be in direct contact with the top surface of the second interlayer insulating layer 150, and may have an overall flat planar profile. The second layer PD4b and the first layer PD4a disposed on the third layer PD4c may also have an overall flat planar profile. Further, the fifth upper pad electrode PD5 may completely cover the fourth upper pad electrode PD4. In other words, referring to FIG. 14, the fifth upper pad electrode PD5 may cover the top surface and both side surfaces of the fourth upper pad electrode PD4 in the first direction DR1.

Accordingly, the second layer PD4b of the fourth upper pad electrode PD4 is not exposed to the outside and is not in direct contact with the side wiring 200, so that the occurrence of galvanic corrosion may be prevented.

Hereinafter, the overall stacked structure of the first pad PAD1 and the overall stacked structure of the second pad PAD2 will be described.

FIG. 15 is a cross-sectional view illustrating a cross section taken along the line X3-X3' of FIG. 8. FIG. 16 is a cross-sectional view illustrating a cross section taken along the line X4-X4' of FIG. 10.

Referring to FIG. 15 in conjunction with FIG. 8, the fourth upper pad electrode PD4 and the fifth pad electrode PD5 may extend from the first region PAD1a of the first pad PAD1 in the second direction DR2 to reach the third region PAD1c and the second region PAD1b. In other words, the first region PAD1a, the second region PAD1b, and the third region PAD1c may be electrically connected. Therefore, the inspection device may be connected to the first pad opening POP1 to measure the resistance value between the fifth upper pad electrode PD5 or the fourth upper pad electrode PD4 and the side wiring 200 that are in contact with each other at the second pad opening POP2.

Referring to FIG. 16 in conjunction with FIG. 10, the pad electrode portion BCLb of the bottom surface connection line BCL may extend in the second direction DR2 to electrically connect the first portion PAD2a and the second portion PAD2b of the second pad PAD2. Further, the lower passivation layer 140 is not disposed on most of the top surface of the first portion PAD2a, so that the first portion PAD2a may be exposed to the outside. Accordingly, the inspection device may be connected to the first portion PAD2a exposed to the outside to measure the resistance value between the second portion PAD2b of the second pad PAD2 and the side wiring 200 that are in contact with each other at the third pad opening POP3.

Hereinafter, a manufacturing method of the display device 10 according to one or more embodiments will be described.

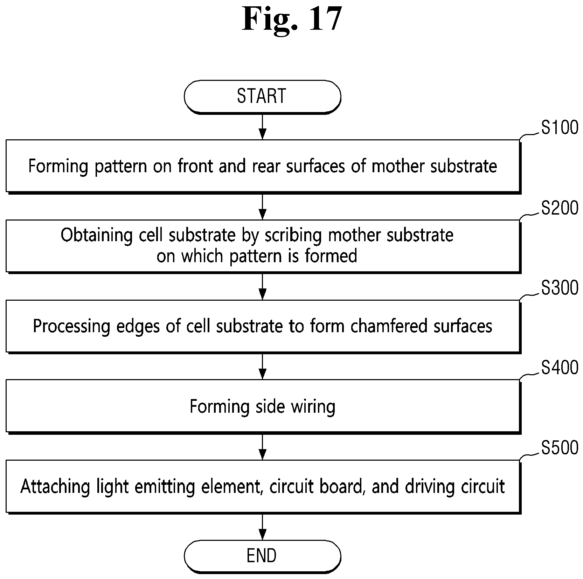

FIGS. 17 to 27 are diagrams illustrating a manufacturing method of a display device according to one or more embodiments.

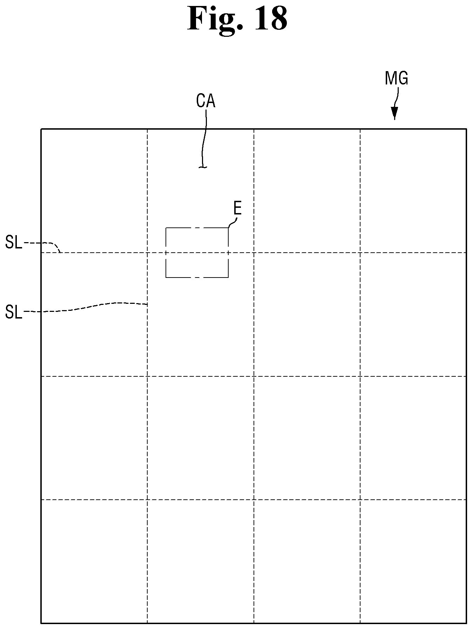

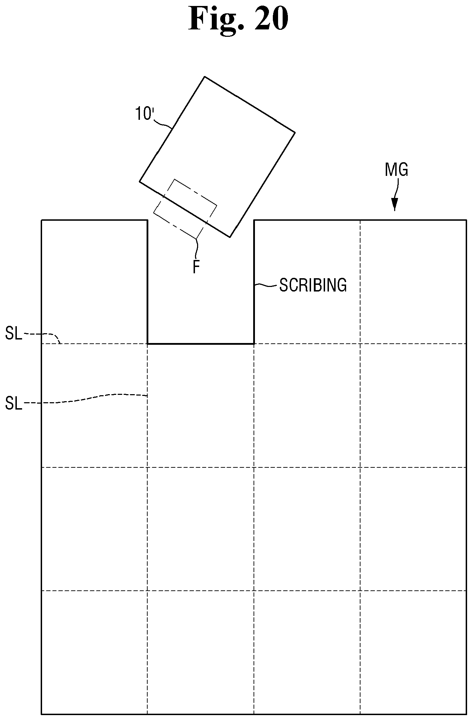

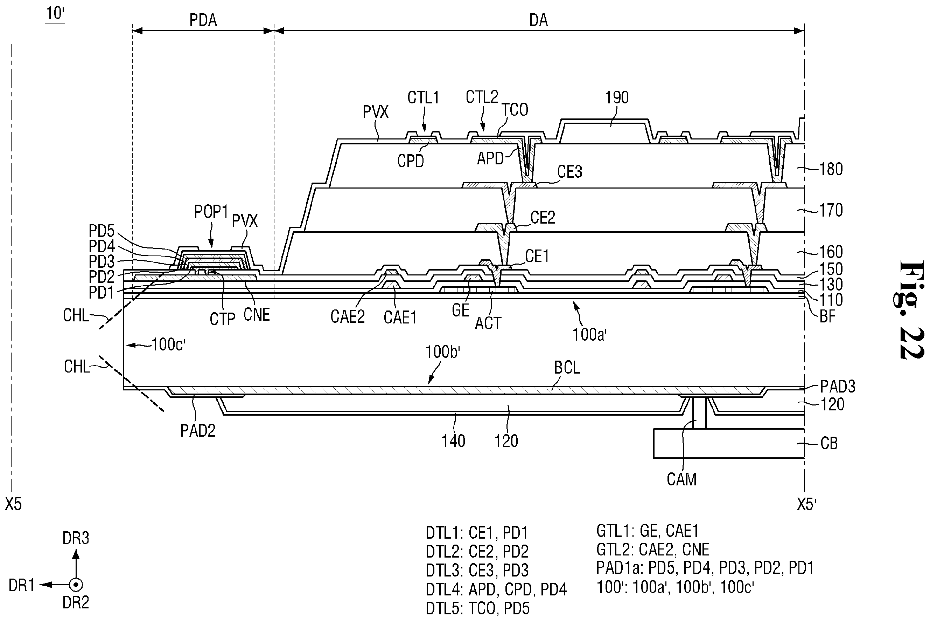

Referring to FIG. 17, the manufacturing method of the display device 10 according to one or more embodiments may include forming a pattern on the front and rear surfaces of a mother substrate MG (see FIG. 18) (step S100), obtaining a cell substrate 100' (see FIGS. 20 and 22) by scribing the mother substrate MG on which the pattern is formed (step S200), processing the edges of the cell substrate 100' to form the chamfered surfaces 100d1 and 100d2 (step S300), forming a side wiring (step S400), and attaching the light emitting element LE, the circuit board CB, and the driving circuit DC (step S500).

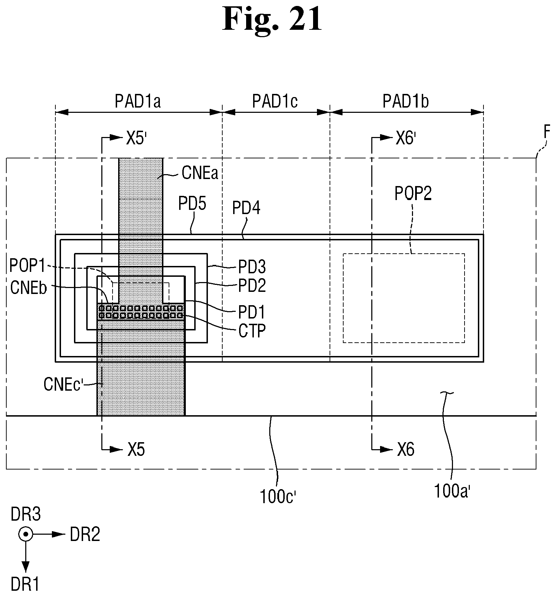

First, referring to FIGS. 18 to 21, a pattern is formed on the front and rear surfaces of the mother substrate MG (step S100) and, then, the mother substrate MG on which the pattern is formed is scribed to obtain a cell 10' (step S200). FIG. 18 is a plan view illustrating cell areas CA and scribing lines SL defined on the mother substrate MG. FIG. 19 is an enlarged view of an area E of FIG. 18, which illustrates a portion corresponding to the area A of FIG. 7. FIG. 20 illustrates the step of obtaining the cell 10' by performing scribing along the scribing lines SL of FIG. 18. FIG. 21 is an enlarged view of an area F of FIG. 20, which illustrates a portion corresponding to an area E of FIG. 18.

The mother substrate MG is a base substrate on which the scribing lines SL partitioning the plurality of cell areas CA are defined. The cell areas CA are arranged in a matrix form, and the scribing lines SL may be arranged in a transverse direction (a horizontal direction in FIG. 18) and a longitudinal direction (a vertical direction in FIG. 18) to define the cell areas CA. The cell area CA may correspond to the cell 10' obtained by the scribing step of cutting the scribing lines SL of the mother substrate MG. In other words, the cell area CA is obtained as the cell 10' by performing the scribing process.

The scribing lines SL of the mother substrate MG may define the edges of the cell substrate 100' included in the cell 10'. In other words, when the scribing lines SL of the mother substrate MG are cut, the side surfaces 100c' of the cell substrate 100' of the cell 10' may be formed. The cell 10' may include patterns remaining on a front surface 100a' and a rear surface 100b' of the cell substrate 100' by scribing patterns formed on the front surface and the rear surface of the mother substrate to be described later.

The patterns formed on the front and rear surfaces of the mother substrate MG may mean a state in which all the elements except the light emitting element and the driver are formed with reference to FIG. 11. Specifically, the patterns mean a state in which the pattern including the active layer ACT, the first gate metal layer GTL1, the second gate metal layer GTL2, the first data metal layer DTL1, the second data metal layer DTL2, the third data metal layer DTL3, the fourth data metal layer DTL4, and the fifth data metal layer DTL5 as the plurality of conductive layers, including the buffer layer BF, the gate insulating layer 110, the first interlayer insulating layer 130, the second interlayer insulating layer 150, and the upper via layer as the plurality of insulating layers, and including the first via layer 160, the second via layer 170, the third via layer 180, and the fourth via layer 190 as the upper via layer is formed in each cell area CA on the top surface of the mother substrate MG, and the pattern including the second pad PAD2, the third pad PAD3, the bottom surface connection line BCL, the lower via layer 120, and the lower passivation layer 140 is formed in each cell area CA on the bottom surface of the mother substrate MG.

Because the method for forming the above-described patterns is widely known in the art, the detailed description thereof will be omitted.

After the scribing step of cutting the scribing lines SL is performed, the mother substrate MG is divided into a plurality of cell substrates 100', and the patterns on the mother substrate MG may remain on the plurality of cell substrates 100' to corresponding to the plurality of cell substrates 100'. The cell substrate 100' may have a rectangular parallelepiped structure or a three-dimensional structure similar to a rectangular parallelepiped. In other words, as shown in FIG. 22, the cell substrate 100' may have a rectangular parallelepiped shape including the front surface 100a', the rear surface 100b', and a plurality of side surfaces. The plurality of side surfaces of the cell substrate 100' may include the first side surface 100c', a second side surface, a third side surface, and a fourth side surface. In this case, the front surface 100a' of the cell substrate 100' corresponds to the first surface 100a of the substrate 100 of the display device 10 described above, the rear surface 100b' of the cell substrate 100' corresponds to the second surface 100b of the substrate 100 of the display device 10 described above, and the first side surface 100c' of the cell substrate 100' corresponds to the first side surface 100c of the substrate 100 of the display device 10. However, the cell substrate 100' may not have surfaces corresponding to the plurality of chamfered surfaces of the substrate 100 of the display device 10. In other words, the cell substrate 100' may refer to the substrate 100 without a plurality of chamfered surfaces, i.e., the substrate 100 that has not been subjected to a chamfered surface forming process to be described later.

The pattern formed on the top surface of the mother substrate MG may include the inspection line CNEc" (e.g., see FIG. 21). Because the pattern formed on the bottom surface of the mother substrate MG is subjected to substantially the same process as that applied to the pattern formed on the top surface of the mother substrate MG, the pattern formed on the top surface of the mother substrate MG will be mainly described hereinafter, and the description of the pattern formed on the bottom surface of the mother substrate MG will be omitted.

The inspection line CNEc" may be connected to the first contact portion CNEb and the first line portion CNEa of the top surface connection line CNE, and may be disposed in each of the plurality of cell areas CA defined on the mother substrate MG. The inspection line CNEc' may provide a region where the inspection device for inspecting whether or not the elements included in the patterns disposed on the top surfaces of the cell areas CA are electrically connected. Specifically, the inspection line CNEc" may extend over the scribing line SL to an inspection pad disposed at the edge of the mother substrate MG to be connected to the inspection pad, and the inspection device may be connected to the inspection pad to inspect whether or not the elements included in the patterns disposed on the top surfaces of the cell areas CA are electrically connected.

Referring to FIG. 19, the inspection line CNEc" may extend toward the scribing line SL on the mother substrate MG to cross the scribing line SL before the scribing process is performed. After the scribing process shown in FIG. 20 is performed, the portion of the inspection line CNEc" on the mother substrate MG that crosses the scribing line SL may also be scribed by the scribing of the scribing line SL. Therefore, the inspection line CNEc" may form a first peeling portion pattern CNEc' having a shape in contact with the end of the front surface 100a' of the cell substrate 100' while extending toward the first side surface 100c' of the cell substrate 100' formed by the scribing process shown in FIG. 21 after the scribing process.

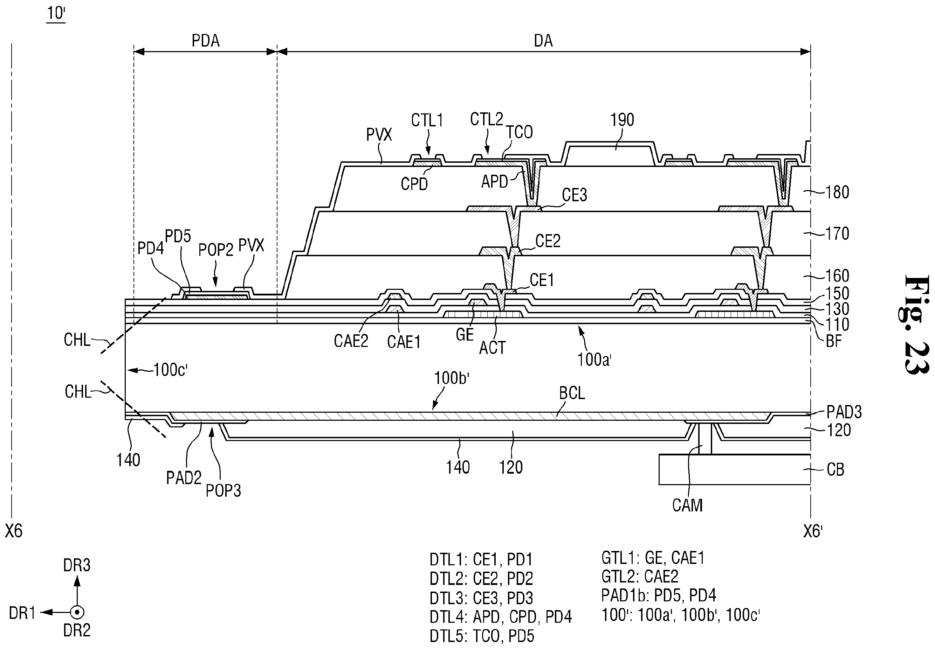

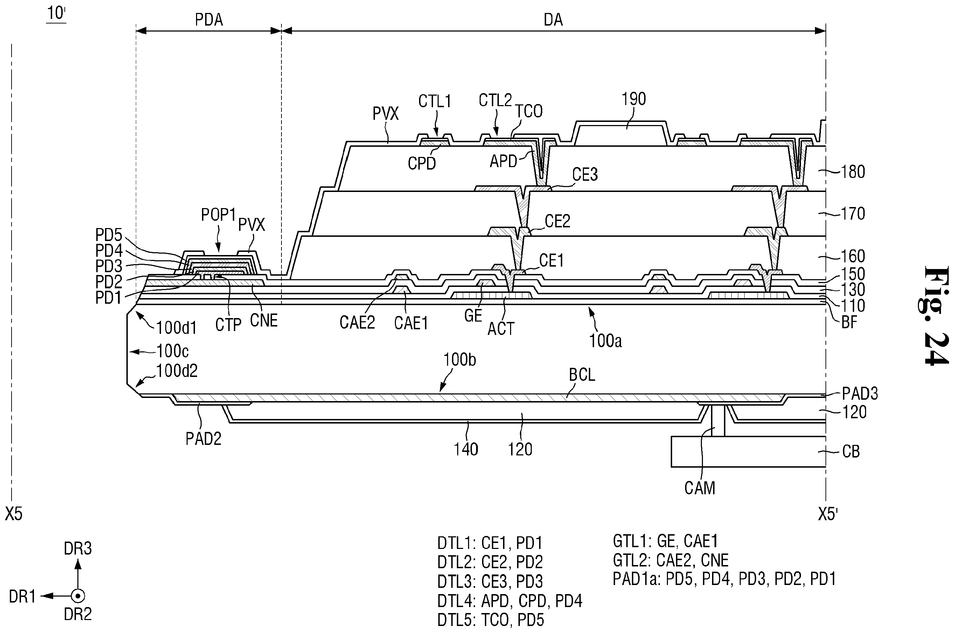

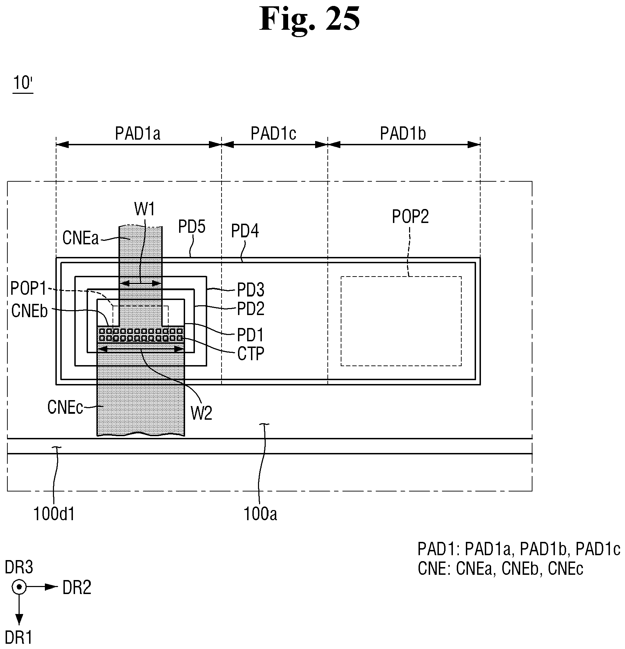

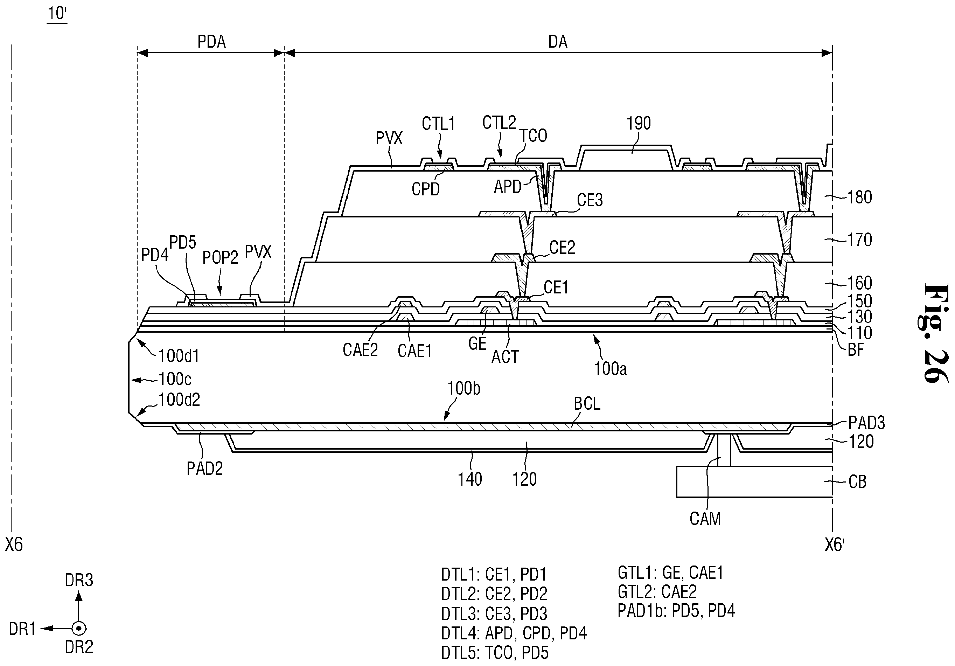

Referring to FIGS. 22 to 26, the edges of the cell substrate 100' of the cell 10' are processed to form chamfered surfaces. For example, the step of forming the chamfered surface may be performed using physical friction. FIG. 22 is a cross-sectional view taken along the line X5-X5' of FIG. 21, and schematically illustrates the structure of the cell 10' in which the first region PAD1a of the first pad PAD1 is disposed. FIG. 23 is a cross-sectional view taken along the line X6-X6' of FIG. 21, and schematically illustrates the structure of the cell 10' in which the second region PAD1b of the first pad PAD1 is disposed. FIG. 24 illustrates the structure of the first portion PAD2a of the first pad PAD1 in which the corners of the cell substrate 100' are processed. FIG. 25 shows the structure of the first pad PAD1 after the step of processing the corners of the cell substrate 100'. FIG. 26 shows the structure of the second region PAD1b of the first pad PAD1 in which the corners of the cell substrate 100' are processed.

As illustrated in FIGS. 22 to 26, the cell substrate 100' may be processed into the substrate 100 having the plurality of chamfered surfaces by removing a part of the corners of the cell substrate 100' by applying physical friction along imaginary chamfered lines CHL near the corners of the cell substrate 100'. In this case, the cell 10' includes the substrate 100.

On the other hand, when the physical friction is applied along the chamfered lines CHL near the corners of the cell substrate 100', some element layers disposed on the front surface 100a' and some element layers disposed on the rear surface 100b' of the cell substrate 100' may be removed along the chamfered lines CHL together with a part of the corners of the cell substrate 100'.

Accordingly, one end of the first peeling portion pattern CNEc' is peeled off, so that one end of the first peeling portion pattern CNEc' may be processed into a first peeling portion CNEc including the first peeling pattern PLA1 as shown in FIG. 25 (and FIG. 8).

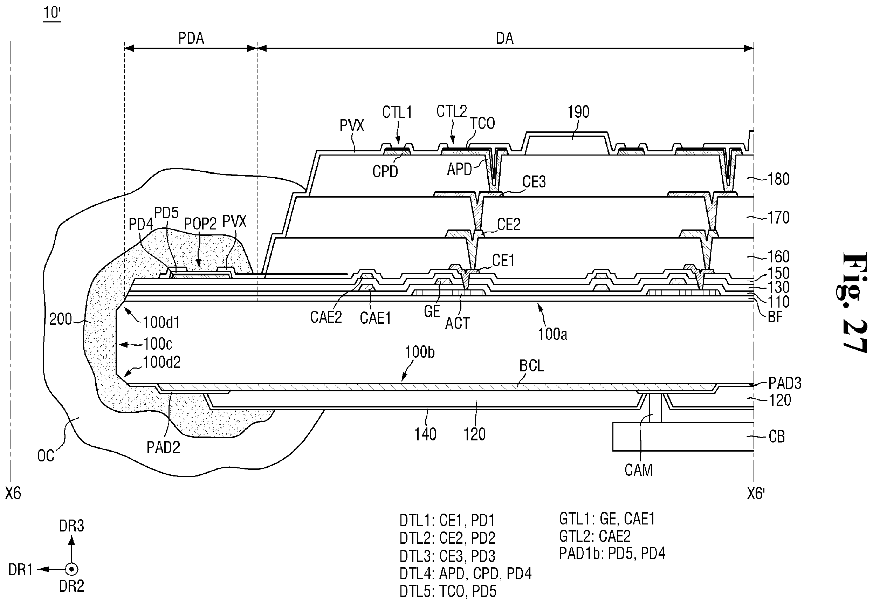

Then, referring to FIG. 27, the side wiring 200 and the overcoat layer OC are formed on one side of the substrate 100 having the plurality of chamfered surfaces. The step of forming the side wiring 200 may be performed by printing a metal pattern on a Si mold, for example, and bringing the Si mold to be in contact with one side of the substrate 100 having the plurality of chamfered surfaces to transfer the metal pattern.

In the substrate 100 having the plurality of chamfered surfaces, the bending angle of the side wiring 200 may become gentle due to the plurality of chamfered surfaces compared to a state in which the plurality of chamfered surfaces are not formed, so that it is possible to prevent occurrence of chipping or cracking in the side wiring 200.

In one or more embodiments, when the side wiring 200 is disposed on the first region PAD1a of the first pad PAD1 as described above, the first peeling portion CNEc and the side wiring 200 overlap and, thus, the contact between the first pad PAD1 and the side wiring 200 may become poor and the side wiring 200 may be disconnected. Therefore, the side wiring 200 may be disposed on the second region PAD1b of the first pad PAD1.

Next, the light emitting element LE, the circuit board CB, and the driving circuit DC are arranged in the cell 10' to manufacture the display device 10.

Hereinafter, a structure of a tiled display including display devices according to one or more embodiments will be described.

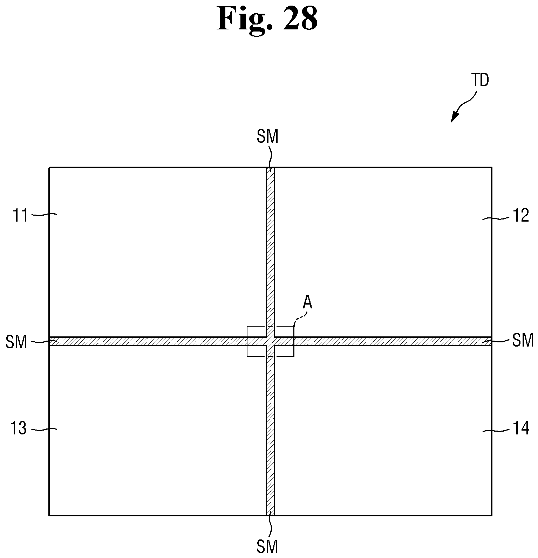

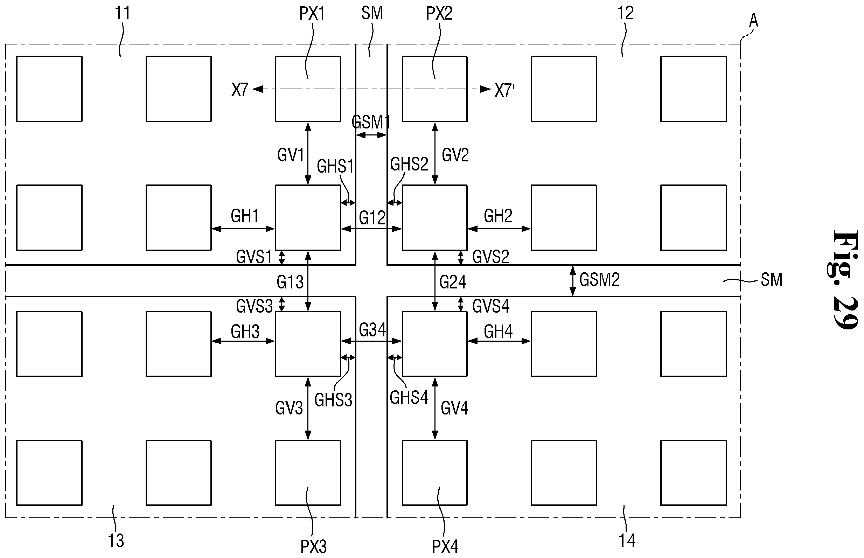

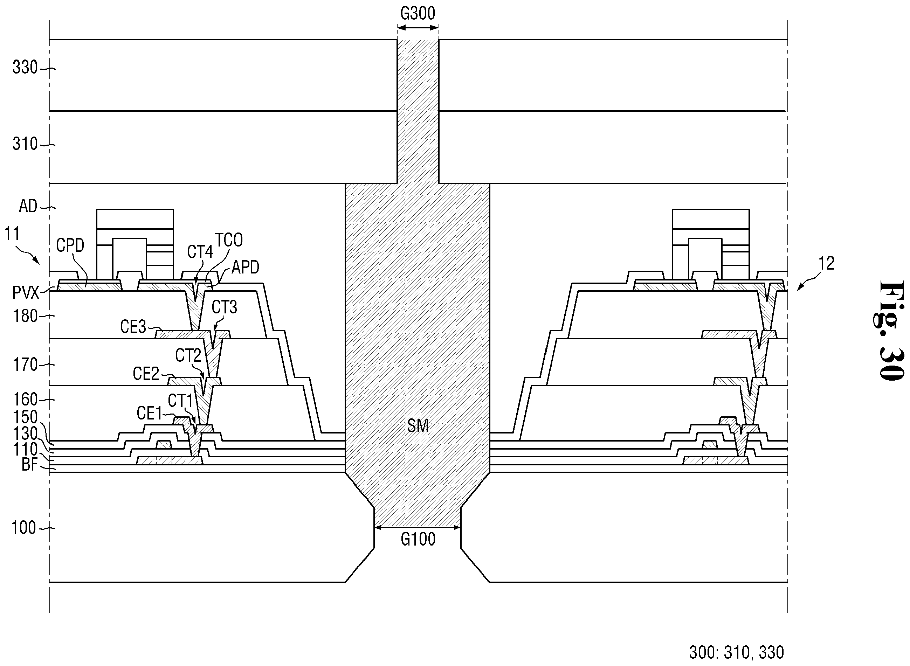

FIG. 28 is a diagram schematically illustrating a tiled display using display devices according to one or more embodiments. FIG. 29 is an enlarged view of an area A of FIG. 28. FIG. 30 is a cross-sectional view illustrating a cross section taken along the line X7-X7' of FIG. 29.

Referring to FIGS. 28 to 29, a tiled display TD may include a plurality of display devices 10, a seam SM, and front covers 300. For simplicity of description, depending on the relative positional relationships of the plurality of display devices 10 shown in FIG. 28, the display device 10 located at the upper left portion is referred to as 'first display device 11', the display device 10 located at the upper right portion is referred to as 'second display device 12', the display device 10 located at the lower left portion is referred to as 'third display device 13', and the display device 10 located at the lower right portion is referred to as 'fourth display device 14'. Although FIG. 28 illustrates that the tiled display device 10 includes four display devices 10, i.e., the first display device 11, the second display device 12, the third display device 13, and the fourth display device 14, the number of display devices 10 that may be included in the tiled display TD of embodiments is not limited thereto. In the present specification, the tiled display TD may be referred to as a tiled display device.

The plurality of display devices 11, 12, 13, and 14 may be arranged in a grid shape. The plurality of display devices 11, 12, 13, and 14 may be arranged in a matrix form in M (M being a positive integer) rows and N (N being a positive integer) columns. Although FIG. 28 illustrates that the first display device 11 and the second display device 12 are adjacent to each other in the first direction DR1, the first display device 11 and the third display device 13 are adjacent to each other in the second direction DR2, the third display device 13 and the fourth display device 14 are adjacent to each other in the first direction DR1, and the second display device 12 and the fourth display device 14 are adjacent to each other in the second direction DR2, the arrangement of the plurality of display devices constituting the tiled display TD of embodiments is not limited thereto. That is, in the tiled display TD, the number and arrangement of display devices may be determined by the size of each of the display device 10 and the tiled display TD and the shape of the tiled display TD. Hereinafter, for simplicity of description, a case where the tiled display TD includes four display devices, and the plurality of display devices 11, 12, 13, and 14 are arranged in two rows and two columns will be mainly described.

The plurality of display devices 11, 12, 13, and 14 constituting the tiled display TD may have the same size, but embodiments of the present disclosure are not limited thereto. For example, the plurality of display devices 11, 12, 13, and 14 may have different sizes.

Each of the plurality of display devices 11, 12, 13, and 14 may have a rectangular shape including long sides and short sides. The plurality of display devices 11, 12, 13, and 14 may be disposed such that the long sides or the short sides thereof are connected to each other. Some or all of the plurality of display devices 11, 12, 13, and 14 may be disposed at the edge of the tiled display TD, and may form one side of the tiled display TD. At least one display device 10 of the plurality of display devices 11, 12, 13, and 14 may be disposed at at least one corner of the tiled display TD, and may form two adjacent sides of the tiled display TD. At least one of the plurality of display devices 11, 12, 13, and 14 may be surrounded by other display devices.

Each of the plurality of display devices 11, 12, 13, and 14 may be substantially the same as the display device 10 described in conjunction with FIG. 1. Therefore, a description of each of the plurality of display devices 11, 12, 13, and 14 will be omitted.

The seam SM may include a coupling member or an adhesive member. In this case, the plurality of display devices 11, 12, 13, and 14 may be connected to each other by the coupling member or the adhesive member of the seam SM. The seam SM may be disposed between the first display device 11 and the second display device 12, between the first display device 11 and the third display device 13, between the second display device 12 and the fourth display device 14, and between the third display device 13 and the fourth display device 14.

Referring to FIG. 29, the seam SM may have a shape of a cross (+) or a plus sign (+) in a plan view in the central region of the tiled display TD in which the first display device 11, the second display device 12, the third display device 13, and the fourth display device 14 are adjacent to each other. The seam SM may be disposed between the first display device 11 and the second display device 12, between the first display device 11 and the third display device 13, between the second display device 12 and the fourth display device 14, and between the third display device 13 and the fourth display device 14.

The first display device 11 may include the first pixels PX1 arranged in a matrix form in a row direction (horizontal direction in FIG. 29) and a column direction (vertical direction in FIG. 29) intersecting the row direction to display an image. The second display device 12 may include second pixels PX2 arranged in a matrix form in the row direction and the column direction to display an image. The third display device 13 may include third pixels PX3 arranged in a matrix form in the row direction and the column direction to display an image. The fourth display device 14 may include fourth pixels PX4 arranged in a matrix form in the row direction and the column direction to display an image. Because the first pixel PX1, the second pixel PX2, the third pixel PX3, and the fourth pixel PX4 are substantially the same as the pixel PX of the display device 10 described above, the detailed description of the structure of the first pixel PX1, the second pixel PX2, the third pixel PX3, and the fourth pixel PX4 will be omitted.

A minimum distance between the first pixels PX1 adjacent in the first direction DR1 may be defined as a first horizontal separation distance GH1, and a minimum distance between the second pixels PX2 adjacent in the first direction DR1 may be defined as a second horizontal separation distance GH2. The first horizontal separation distance GH1 and the second horizontal separation distance GH2 may be substantially the same.

The seam SM may be disposed between the first pixel PX1 and the second pixel PX2 adjacent in the row direction. A minimum distance G12 between the first pixel PX1 and the second pixel PX2 adjacent in the row direction may be the sum of a minimum distance GHS1 between the first pixel PX1 and the seam SM in the row direction, a minimum distance GHS2 between the second pixel PX2 and the seam SM in the row direction, and a width GSM1 of the seam SM in the row direction.

The minimum distance G12 between the first pixel PX1 and the second pixel PX2 adjacent in the row direction, the first horizontal separation distance GH1, and the second horizontal separation distance GH2 may be substantially the same. To this end, the minimum distance GHS1 between the first pixel PX1 and the seam SM in the row direction may be smaller than the first horizontal separation distance GH1, and the minimum distance GHS2 between the second pixel PX2 and the seam SM in the row direction may be smaller than the second horizontal separation distance GH2. In addition, the width GSM1 of the seam SM in the row direction may be smaller than the first horizontal separation distance GH1 or the second horizontal separation distance GH2.

A minimum distance between the third pixels PX3 adjacent in the row direction may be defined as a third horizontal separation distance GH3, and a minimum distance between the fourth pixels PX4 adjacent in the row direction may be defined as a fourth horizontal separation distance GH4. The third horizontal separation distance GH3 and the fourth horizontal separation distance GH4 may be substantially the same.

The seam SM may be disposed between the third pixel PX3 and the fourth pixel PX4 adjacent in the row direction. A minimum distance G34 between the third pixel PX3 and the fourth pixel PX4 adjacent in the row direction may be the sum of a minimum distance GHS3 between the third pixel PX3 and the seam SM in the row direction, a minimum distance GHS4 between the fourth pixel PX4 and the seam SM in the row direction, and a width GSM1 of the seam SM in the row direction.

The minimum distance G34 between the third pixel PX3 and the fourth pixel PX4 adjacent in the first direction DR1, the third horizontal separation distance GH3, and the fourth horizontal separation distance GH4 may be substantially the same. To this end, the minimum distance GHS3 between the third pixel PX3 and the seam SM in the row direction may be smaller than the third horizontal separation distance GH3, and the minimum distance GHS4 between the fourth pixel PX4 and the seam SM in the row direction may be smaller than the fourth horizontal separation distance GH4. In addition, the width GSM1 of the seam SM in the row direction may be smaller than the third horizontal separation distance GH3 or the fourth horizontal separation distance GH4.

The minimum distance between the first pixels PX1 adjacent in the column direction may be defined as a first vertical separation distance GV1, and the minimum distance between the third pixels PX3 adjacent in the column direction may be defined as a third vertical separation distance GV3. The first vertical separation distance GV1 and the third vertical separation distance GV3 may be substantially the same.

The seam SM may be disposed between the first pixel PX1 and the third pixel PX3 adjacent in the column direction. A minimum distance G13 between the first pixel PX1 and the third pixel PX3 adjacent in the column direction may be the sum of a minimum distance GVS1 between the first pixel PX1 and the seam SM in the column direction, a minimum distance GVS3 between the third pixel PX3 and the seam SM in the column direction, and a width GSM2 of the seam SM in the column direction.

The minimum distance G13 between the first pixel PX1 and the third pixel PX3 adjacent in the column direction, the first vertical separation distance GV1, and the third vertical separation distance GV3 may be substantially the same. To this end, the minimum distance GVS1 between the first pixel PX1 and the seam SM in the column direction may be smaller than the first vertical separation distance GV1, and the minimum distance GVS3 between the third pixel PX3 and the seam SM in the column direction may be smaller than the third vertical separation distance GV3. Further, the width GSM2 of the seam SM in the column direction may be smaller than the first vertical separation distance GV1 or the third vertical separation distance GV3.

The minimum distance between the second pixels PX2 adjacent in the column direction may be defined as a second vertical separation distance GV2, and the minimum distance between the fourth pixels PX4 adjacent in the column direction may be defined as a fourth vertical separation distance GV4. The second vertical separation distance GV2 and the fourth vertical separation distance GV4 may be substantially the same.

The seam SM may be disposed between the second pixel PX2 and the fourth pixel PX4 adjacent in the column direction. A minimum distance G24 between the second pixel PX2 and the fourth pixel PX4 adjacent in the column direction may be the sum of a minimum distance GVS2 between the second pixel PX2 and the seam SM in the column direction, a minimum distance GVS4 between the fourth pixel PX4 and the seam SM in the column direction, and the width GSM2 of the seam SM in the column direction.

The minimum distance G24 between the second pixel PX2 and the fourth pixel PX4 adjacent in the column direction, the second vertical separation distance GV2, and the fourth vertical separation distance GV4 may be substantially the same. To this end, the minimum distance GVS2 between the second pixel PX2 and the seam SM in the column direction may be smaller than the second vertical separation distance GV2, and the minimum distance GVS4 between the fourth pixel PX4 and the seam SM in the column direction may be smaller than the fourth vertical separation distance GV4. Further, the width GSM2 of the seam SM in the column direction may be smaller than the second vertical separation distance GV2 or the fourth vertical separation distance GV4.

In order to prevent the seam SM from being visually recognized between images displayed by the plurality of display devices 11, 12, 13, and 14, the minimum distance between the pixels PX of adjacent display devices 10 may be substantially the same as the minimum distance between the pixels PX of each of the display devices 10 as shown in FIG. 29.

Referring to FIG. 30, the plurality of front covers 300 may be disposed above each of the plurality of display devices 11, 12, 13 and 14. For simplicity of description, the front cover 300 disposed above the first display device 11 is referred to as 'first front cover', and the front cover 300 disposed above the second display device 12 is referred to as 'second front cover 300', the front cover 300 disposed above the third display device 13 is referred to as 'third front cover', and the front cover 300 disposed above the fourth display device 14 is referred to as 'fourth front cover'. The plurality of display devices 11, 12, 13, and 14 and the plurality of front covers 300 corresponding thereto may be bonded to each other by an adhesive member AD. FIG. 30 illustrates the arrangement structure of the first display device 11 and the second display device 12 and the first front cover and the second front cover respectively corresponding thereto. Because the arrangement structure of the third display device 13 and the fourth display device 14 and the third front cover and the fourth front cover corresponding thereto is substantially the same as the arrangement structure of the first display device 11 and the second display device 12 and the first front cover and the second front cover corresponding thereto, the first front cover and the second front cover will be mainly described hereinafter, and the detailed description of the third front cover and the fourth front cover will be omitted.

The first front cover may be disposed on the first display device 11 and protrude more than the substrate 100 of the first display device 11. Therefore, a gap G100 between the substrate 100 of the first display device 11 and the substrate 100 of the second display device 12 may be greater than a gap G300 between the first front cover and the second front cover.

Each of the plurality of front covers 300 may include a light transmittance control layer 310 and an anti-glare layer 330.

As described above, each of the plurality of front covers 300 may be adhered to the display device 10 corresponding thereto by the adhesive member AD. The adhesive member AD may be a transparent adhesive member capable of transmitting light. For example, the adhesive member AD may be an optically clear adhesive film or an optically clear resin.

The light transmittance control layer 310 may be disposed on the adhesive member AD. The light transmittance control layer 310 may be designed to reduce transmittance of external light or light reflected from the first display device 11 and the second display device 12. Further, because the front cover 300 protrudes more than the substrate 100 as described above, the light transmittance control layer 310 included in the front cover 300 may also protrude more than the substrate 100. Accordingly, the gap G100 between the substrate 100 of the first display device 11 and the substrate 100 of the second display device 12 may be prevented from being visually recognized from the outside.

The anti-glare layer 330 may be disposed on the light transmittance control layer 310. The anti-glare layer 330 may be designed to diffusely reflect external light in order to prevent a decrease in visibility of an image due to reflection of external light. Accordingly, the contrast ratio of images displayed by the first display device 11 and the second display device 12 may be increased due to the anti-glare layer 330.

The anti-glare layer 330 may be implemented as a polarizing plate, and the light transmittance control layer 310 may be implemented as a phase delay layer, but the embodiments of the present disclosure are not limited thereto.

Hereinafter, a driving method of the tiled display TD according to one or more embodiments will be described.

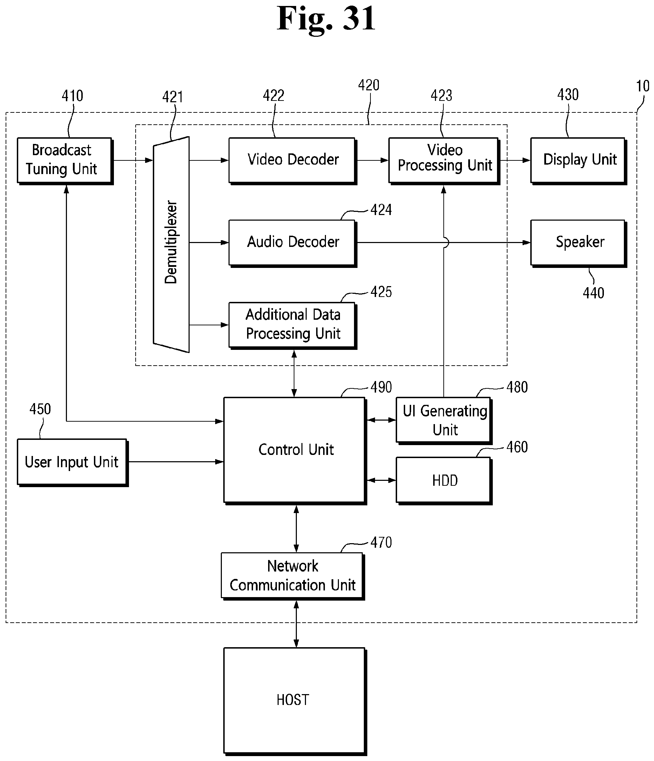

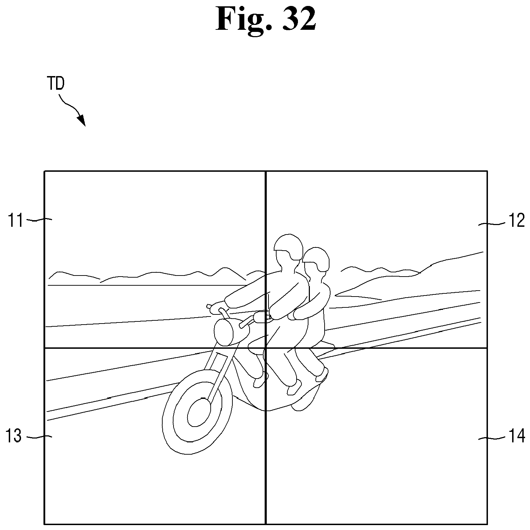

FIG. 31 is a block diagram illustrating a structure of a tiled display according to one or more embodiments. FIG. 32 is a diagram illustrating a state in which a tiled display using display devices according to one or more embodiments is driven.

Referring to FIGS. 31 and 32, the tiled display TD according to one or more embodiments may include a host system HOST, a broadcast tuning unit 410 included in each of the plurality of display devices 11, 12, 13, and 14, a signal processing unit 420, a display unit 430, a speaker 440, a user input unit 450, an HDD 460, a network communication unit 470, a UI generator 480, and a control unit 490. FIG. 31 illustrates the host system HOST and the first display device 11.

The host system HOST may be implemented as any one of a television system, a home theater system, a set-top box, a navigation system, a DVD player, a Blu-Ray player, a personal computer (PC), a mobile phone system, and a tablet.

A user's command may be inputted to the host system HOST in various formats. For example, a command by a user's touch input may be inputted to the host system HOST. Alternatively, a user's command by a keyboard input or a button input of a remote controller may be inputted to the host system HOST.

The host system HOST may receive original video data corresponding to an original image from the outside. The host system HOST may divide the original video data by the number of the display devices 10. For example, in response to the first display device 11, the second display device 12, the third display device 13, and the fourth display device 14 (e.g., see, FIG. 28), the host system HOST may divide the original video data into a first video data corresponding to a first image, a second video data corresponding to a second image, a third video data corresponding to a third image, and a fourth video data corresponding to a fourth image. The host system HOST may transmit the first video data to the first display device 11, the second video data to the second display device 12, the third video data to the third display device 13, and the fourth video data to the fourth display device 14.

The first display device 11 may display the first image according to the first video data, the second display device 12 may display the second image according to the second video data, the third display device 13 may display the third image according to the third video data, and the fourth display device 14 may display the fourth image according to the fourth video data. Accordingly, the user may view the original image in which the first to fourth images displayed on the first to fourth display devices 11, 12, 13 and 14 are combined as shown in FIG. 32.

Each of the plurality of display devices 11, 12, 13, and 14 constituting the tiled display TD may further include the broadcast tuning unit 410, the signal processing unit 420, the display unit 430, the speaker 440, the user input unit 450, the HDD 460, the network communication unit 470, the UI generation unit 480, and the control unit 490. The components included in the plurality of display devices 11, 12, 13, and 14 are substantially the same. Therefore, hereinafter, for simplicity of description, the components included in the first display device 11 will be mainly described below, and the description of the components included in the second display device 12, the third display device 13, and the fourth display device 14 will be omitted.

The broadcast tuning unit 410 may tune a desired channel frequency (e.g., a predetermined channel frequency) under the control of the control unit 490 to receive a broadcast signal of a corresponding channel through an antenna. The broadcast tuning unit 410 may include a channel detection module and an RF demodulation module.

The broadcast signal demodulated by the broadcast tuning unit 410 is processed by the signal processing unit 420 and outputted to the display unit 430 and the speaker 440. Here, the signal processing unit 420 may include a demultiplexer 421, a video decoder 422, a video processor 423, an audio decoder 424, and an additional data processor 425.

The demultiplexer 421 separates the demodulated broadcast signal into a video signal, an audio signal, and additional data. The video signal, the audio signal, and the additional data are restored by the video decoder 422, the audio decoder 424, and the additional data processor 425, respectively. In this case, the video decoder 422, the audio decoder 424, and the additional data processor 425 restore them in a decoding format corresponding to an encoding format of when the broadcast signal is transmitted.

On the other hand, the decoded video signal is converted by the video processor 423 to fit the vertical frequency, resolution, aspect ratio, and the like that meet the output standard of the display unit 430, and the decoded audio signal is outputted to the speaker 440.

The display unit 430, which is a device for displaying an image, includes the pixel PX, the driver, and the like described above.

The user input unit 450 may receive a signal transmitted by the host system HOST. The user input unit 450 may be provided to allow the user to select channels transmitted by the host system HOST and select commands related to communication with other display devices as well as data related to selection and manipulation of a user interface (UI) menu, and to allow data for input to be inputted.

The HDD 460 stores various software programs including OS programs, recorded broadcast programs, videos, photos, and other data, and may be formed of a storage medium such as a hard disk or non-volatile memory.

The network communication unit 470 is for short-distance communication with the host system HOST and other display devices, and may be implemented with a communication module including an antenna pattern that can implement mobile communication, data communication, Bluetooth, RF, Ethernet, or the like.

The network communication unit 470 may transmit/receive a wireless signal to/from at least one of a base station, an external terminal, or a server on a mobile communication network constructed according to technical standards or communication methods (e.g., global system for mobile communication (GSM), code division multi access (CDMA), CDMA2000, enhanced voice-data optimized or enhanced voice-data only (EV-DO), wideband CDMA (WCDMA), high speed downlink packet access (HSDPA), high speed uplink packet access (HSUPA), long term evolution (LTE), long term evolution-advanced (LTE-A), 5G, and the like) for mobile communication through the antenna pattern to be described later.

The network communication unit 470 may transmit/receive a wireless signal in a communication network according to wireless internet techniques through the antenna pattern to be described later. Examples of the wireless internet techniques include wireless LAN (WLAN), wireless-fidelity (Wi-Fi), Wi-Fi direct, digital living network alliance (DLNA), wireless broadband (WiBro), world interoperability for microwave access (WiMAX), high speed downlink packet access (HSDPA), high speed uplink packet access (HSUPA), long term evolution (LTE), long term evolution-advanced (LTE-A), and the like. The antenna pattern transmits and receives data according to at least one of wireless internet techniques including even internet techniques not listed above.

The UI generation unit 480 generates a UI menu for communication with the host system HOST and other display devices, and may be implemented by an algorithm code and an On-Screen Display (OSD) Integrated Circuit (IC) (OSD IC). The UI menu for communication with the host system HOST and other display devices may be a menu for designating a counterpart digital TV for communication and selecting a desired function.

The control unit 490 is in charge of overall control of the first display device 11, and communication control of the host system HOST and the second to fourth display devices 12, 13, and 14. The control unit 490 may be implemented by a microcontroller unit MCU in which a corresponding algorithm code for control is stored and the stored algorithm code is executed.

In response to the input and selection of the user input unit 450, the control unit 490 controls to transmit a corresponding control command and data to the host system HOST and the second to fourth display devices 12, 13, and 14 through the network communication unit 470. When receiving a suitable control command (e.g., a predetermined control command) and data from the host system HOST and the second to fourth display devices 12, 13, and 14, the control unit 490 performs an operation according to the corresponding control command.

Hereinafter, another embodiment of the display device 10 will be described. In the following embodiments, description of the same components as those of the above-described embodiment, which are denoted by like reference numerals, will be omitted or simplified, and differences will be mainly described.

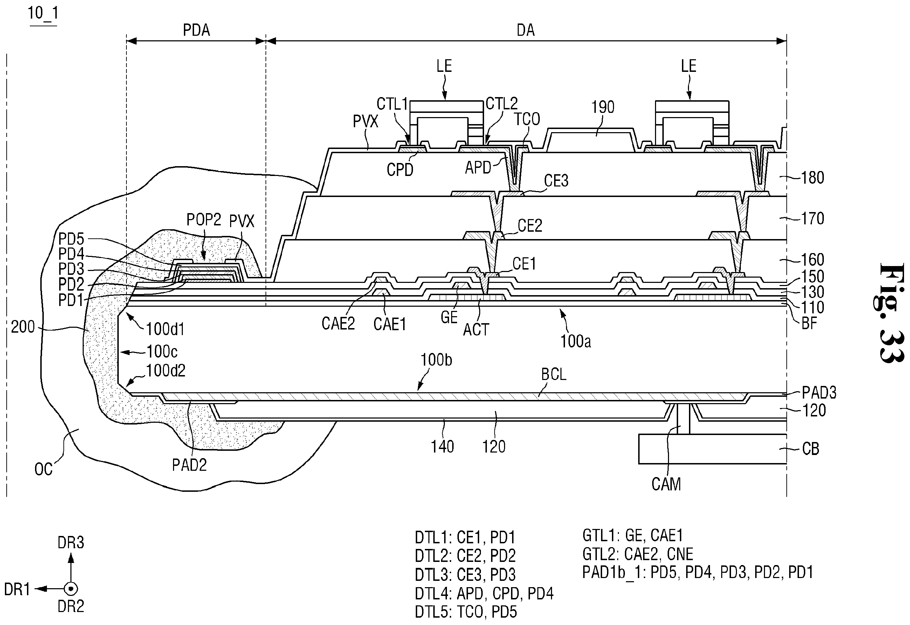

FIG. 33 is a structural diagram schematically illustrating a structure of a second region of a first pad of a display device according to one or more embodiments.

Referring to FIG. 33, a case where a second region PAD1b_1 of the first pad PAD1 of the display device 10_1 according to the present embodiment may include the first upper pad electrode PD1, the second upper pad electrode PD2, and the third upper pad electrode PD3 as well as the fourth upper pad electrode PD4 and the fifth upper pad electrode PD5 is illustrated.

Because the pad contact hole is not formed in the second region PAD1b_1 as described above, the first upper pad electrode PD1, the second upper pad electrode PD2, the third upper pad electrode PD3, the fourth upper pad electrode PD4, and the fifth upper pad electrode PD5 may be stacked with a substantially flat planar profile without a bent portion. Accordingly, the step of forming the first pad PAD1 is further simplified, and the aluminum layer of the fourth upper pad electrode PD4 is not exposed, which makes it possible to prevent corrosion caused by the contact with the side wiring.

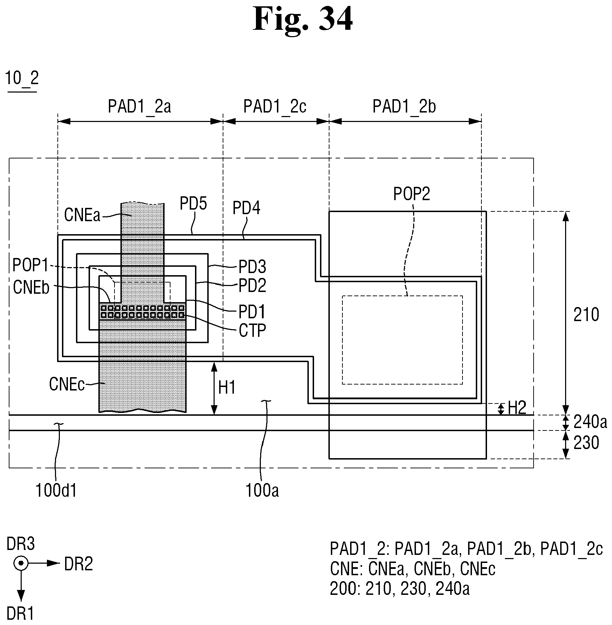

FIG. 34 is a plan view schematically illustrating a planar profile shape of a first pad of a display device according to one or more embodiments.

Referring to FIG. 34, a case where a first pad PAD1_2 of a display device 10_2 according to the present embodiment may have an asymmetric shape is illustrated. For example, a separation distance H1 between a first region PAD1_2a of the first pad PAD1_2 and the first chamfered surface 100d1 in the first direction DR1 may be greater than a separation distance H2 between a second region PAD1_2b thereof and the first chamfered surface 100d1 in the first direction DR1.

As described above, in the case of performing the step of processing the first chamfered surface 100d1, one end of the first peeling portion pattern CNEc' (see FIGS. 21 to 25) is peeled off to form the first peeling portion CNEc. When one surface of the first region PAD1_2a in the first direction DR1 becomes close to the first chamfered surface 100d1 due to the short separation distance H1 between the first region PAD1_2a and the first chamfered surface 100d1 in the first direction DR1, the first contact portion CNEb may be peeled off when the first peeling portion pattern CNEc' is peeled off. Therefore, it is required to ensure a certain separation distance H1 between the first region PAD1_2a and the chamfered surfaces 100d1 in the first direction DR1.

On the other hand, in the case of the second region PAD1_2b where the second pad opening POP2 in contact with the side wiring 200 is formed, the contact between the side wiring 200 and the second region PAD1_2b of the first pad PAD1_2 becomes easier as the separation distance H2 between the second PAD1_2b and the first chamfered surface 100d1 in the first direction DR1 becomes smaller, so that it is necessary to reduce or minimize the separation distance H2 between the second region PAD1_2b and the first chamfered surface 100d1 in the first direction DR1.

Accordingly, the separation distance H1 between the first region PAD1_2a of the first pad PAD1_2 and the first chamfered surface 100d1 in the first direction DR1 is set to be greater than the separation distance H2 between the second region PAD1_2b and the first chamfered surface 100d1 in the first direction DR1, so that it is possible to make the contact between the side wiring 200 and the second region PAD1_2b easier and to prevent the first contact portion CNEb from being peeled off when the first peeling portion pattern CNEc' is peeled off.

In one or more embodiments, a third region PAD1_2c connecting the first region PAD1_2a and the second region PAD1_2b of the first pad PAD1_2 may be bent at least once, but embodiments of the present disclosure are not limited thereto. For example, the third region PAD1_2c may have a diagonal shape crossing between the first direction DR1 and the second direction DR2.

As discussed, embodiments may provide a display device comprising: a substrate comprising a first surface and a second surface opposite to the first surface; a light emitting element on the first surface of the substrate; a top surface pad on the first surface of the substrate and spaced from the light emitting element; a driving circuit on the second surface of the substrate arranged to apply a driving signal for driving the light emitting element; a top surface connection line between the first surface of the substrate and the top surface pad arranged to electrically connect the top surface pad to the light emitting element; an interlayer insulating layer between the top surface connection line and the top surface pad; and a side wiring on the top surface pad arranged to connect the top surface pad to the driving circuit, wherein the top surface pad comprises: a first region in direct contact with the top surface connection line through a contact hole penetrating the interlayer insulating layer; and a second region that does not overlap the top surface connection line, wherein the side wiring overlaps the second region of the top surface pad and does not overlap the first region.

The first surface may be a front facing surface. The first surface may be top surface.

The first surface may have a rectangular shape with short sides in a first direction and long sides in a second direction.

The second surface may be a rear facing surface. The second surface may be bottom surface.

The side wiring may connect a top surface pad to a bottom surface pad.

A plurality of top surface pads (or first pads) may be provided. A plurality of bottom surface pads (or second pads) may be provided. A plurality of side wirings may respectively connect a top surface pad to a bottom surface pad.

A plurality of side surfaces may be disposed between the first surface and the second surface.

A plurality of chamfered surfaces may be provided. The plurality of chamfered surfaces may be obliquely facing surfaces, i.e. facing directions that are not orthogonal to the first, second or side surfaces. The plurality of chamfered surfaces may be disposed between the first surface and the plurality of side surfaces and between the second surface and the plurality of side surfaces.

Hence, instead of the plurality of side surfaces meeting the first surface at right angles, the plurality of side surfaces may be connected to the first surface by the plurality of chamfered surfaces. Likewise, instead of the plurality of side surfaces meeting the second surface at right angles, the plurality of side surfaces may be connected to the second surface by the plurality of chamfered surfaces.

The side wiring may include a first flat portion, a first inclined portion, a connection portion, a second inclined portion, and a second flat portion.

The first flat portion may be a portion disposed on the first surface of the substrate. The first flat portion may be electrically connected to the first pad.

The first inclined portion may be a portion disposed on the first chamfered surface of the substrate. The first inclined portion may form a slope along a direction in which the first chamfering surface is inclined. The first inclined portion may be disposed between the first flat portion and the connection portion.

The connection portion may be a portion disposed on a side surface of the substrate. The connection portion may be disposed between the first inclined portion and the second inclined portion.

The second inclined portion of the side wiring may be a portion disposed on the second chamfered surface of the substrate. The second inclined portion may form a slope along a direction in which the second chamfering surface is inclined. The second inclined portion may be disposed between the second flat portion and the connection portion.

The second flat portion may be a portion disposed on the second surface of the substrate. The second flat portion may be electrically connected to the second pad.

Embodiments may provide a tiled display device comprising a plurality of above mentioned display devices.

Embodiments may provide a display device comprising: a substrate comprising a first surface and a second surface opposite to the first surface, a first chamfered surface extending from one side of the first surface, a second chamfered surface extending from one side of the second surface, and a first side surface connecting the first chamfered surface to the second chamfered surface; a light emitting element on the first surface of the substrate; a first pad on the first surface of the substrate and spaced from the light emitting element; a top surface connection line between the first surface of the substrate and the first pad to electrically connect the first pad arranged to the light emitting element; a driving circuit on the second surface of the substrate arranged to apply a driving signal for driving the light emitting element; and a side wiring on the first pad arranged to electrically connect the first pad to the driving circuit, wherein the top surface connection line comprises: a first contact portion electrically connected to the first pad; and a first peeling portion extending in a direction toward the first chamfered surface from the first contact portion, wherein the side wiring does not overlap the top surface connection line.

Embodiments may provide a tiled display device comprising a plurality of display devices and a seam located between the plurality of display devices, wherein a first display device from among the plurality of display devices comprises: a substrate comprising a first surface and a second surface opposite to the first surface, a first chamfered surface extending from one side of the first surface, a second chamfered surface extending from one side of the second surface, and a first side surface connecting the first chamfered surface to the second chamfered surface; light emitting elements on the first surface of the substrate; a first pad on the first surface of the substrate and spaced from the light emitting elements; a top surface connection line between the first surface of the substrate and the first pad arranged to electrically connect the first pad to the light emitting elements; a driving circuit on the second surface of the substrate arranged to apply a driving signal for driving the light emitting elements; and a side wiring on the first pad arranged to electrically connect the first pad to the driving circuit, wherein the first pad comprises: a first region overlapping the top surface connection line; and a second region not overlapping the top surface connection line, wherein the side wiring overlaps the second region of the first pad without overlapping the first region.

In concluding the detailed description, those skilled in the art will appreciate that many variations and modifications can be made to the embodiments without substantially departing from the principles and scope of the present disclosure. Therefore, the embodiments of the present disclosure are used in a generic and descriptive sense only and not for the purposes of limitation.

## Claims

1. A display device comprising:
a substrate comprising a first surface and a second surface opposite to the first surface;
a light emitting element on the first surface of the substrate;
a top surface pad on the first surface of the substrate and spaced from the light emitting element;
a driving circuit on the second surface of the substrate arranged to apply a driving signal for driving the light emitting element;
a top surface connection line between the first surface of the substrate and the top surface pad arranged to electrically connect the top surface pad to the light emitting element;
an interlayer insulating layer between the top surface connection line and the top surface pad; and
a side wiring on the top surface pad arranged to connect the top surface pad to the driving circuit, wherein the top surface pad comprises:
a first region in direct contact with the top surface connection line through a contact hole penetrating the interlayer insulating layer; and
a second region that does not overlap the top surface connection line,
wherein the side wiring overlaps the second region of the top surface pad and does not overlap the first region.

2. The display device of claim 1, wherein the top surface pad has a planar profile in which a stepped portion is located along the contact hole in the first region, and has a flat planar profile in the second region.

3. The display device of claim 2, wherein the top surface pad comprises:
a first pad electrode; and
a second pad electrode on the first pad electrode;
optionally wherein in the second region, the second pad electrode completely covers the first pad electrode.

4. The display device of claim 3, wherein a standard reduction potential value of metal contained in the first pad electrode and a standard reduction potential value of metal contained in the side wiring are different from each other.

5. The display device of any one of claims 1 to 3, wherein the first pad electrode contains aluminum, Al,
wherein the second pad electrode contains a transparent conductive oxide, and
wherein the side wiring contains silver, Ag.

6. The display device of claim 3 or any preceding claim when dependent on claim 3, further comprising a passivation layer on the top surface pad,
wherein the passivation layer comprises:
a first pad opening exposing the second pad electrode in the first region of the top surface pad; and
a second pad opening exposing the second pad electrode in the second region of the top surface pad;
optionally wherein the light emitting element is a flip chip type micro light emitting diode.

7. A display device comprising:
a substrate comprising a first surface and a second surface opposite to the first surface, a first chamfered surface extending from one side of the first surface, a second chamfered surface extending from one side of the second surface, and a first side surface connecting the first chamfered surface to the second chamfered surface;
a light emitting element on the first surface of the substrate;
a first pad on the first surface of the substrate and spaced from the light emitting element;
a top surface connection line between the first surface of the substrate and the first pad to electrically connect the first pad arranged to the light emitting element;
a driving circuit on the second surface of the substrate arranged to apply a driving signal for driving the light emitting element; and
a side wiring on the first pad arranged to electrically connect the first pad to the driving circuit, wherein the top surface connection line comprises:
a first contact portion electrically connected to the first pad; and
a first peeling portion extending in a direction toward the first chamfered surface from the first contact portion,
wherein the side wiring does not overlap the top surface connection line.

8. The display device of claim 7, wherein the first peeling portion extends on the first surface to a vicinity of a boundary between the first surface and the first chamfered surface.

9. The display device of claim 8, wherein the side wiring is on the first surface, the first side surface, and the second surface of the substrate;
wherein the display device further comprising a second pad between the side wiring and the second surface of the substrate and electrically connected to the side wiring.

10. The display device of claim 9, wherein the second pad comprises:
a first portion overlapping the side wiring; and
a second portion spaced from the first portion without overlapping the side wiring,
wherein the second portion of the second pad comprises:
a second contact portion in contact with the side wiring; and
a second peeling portion extending in a direction toward the second chamfered surface from the second contact portion;
optionally wherein the second peeling portion extends on the second surface to a vicinity of a boundary between the second surface and the second chamfered surface;
optionally further comprising a bottom surface connection line between the second pad and the second surface of the substrate, wherein the bottom surface connection line comprises: a pad electrode portion electrically connecting the first portion and the second portion of the second pad; and a line portion electrically connecting the second portion of the second pad to the driving circuit.

11. A tiled display device comprising a plurality of display devices and a seam located between the plurality of display devices,
wherein a first display device from among the plurality of display devices comprises:
a substrate comprising a first surface and a second surface opposite to the first surface, a first chamfered surface extending from one side of the first surface, a second chamfered surface extending from one side of the second surface, and a first side surface connecting the first chamfered surface to the second chamfered surface;
light emitting elements on the first surface of the substrate;
a first pad on the first surface of the substrate and spaced from the light emitting elements;
a top surface connection line between the first surface of the substrate and the first pad arranged to electrically connect the first pad to the light emitting elements;
a driving circuit on the second surface of the substrate arranged to apply a driving signal for driving the light emitting elements; and
a side wiring on the first pad arranged to electrically connect the first pad to the driving circuit,
wherein the first pad comprises:
a first region overlapping the top surface connection line; and
a second region not overlapping the top surface connection line,
wherein the side wiring overlaps the second region of the first pad without overlapping the first region.

12. The tiled display device of claim 11, wherein each of the light emitting elements is a flip chip type micro light emitting diode.

13. The tiled display device of claim 11 or 12, wherein the substrate comprises glass.

14. The tiled display device of any one of claims 11 to 13, wherein the side wiring is on the first surface, the second surface, and the first side surface of the substrate;
optionally further comprising a bottom surface connection line between the side wiring and the second surface of the substrate, wherein one end of the bottom surface connection line is connected to the driving circuit, and the other end of the bottom surface connection line is connected to the side wiring.

15. The tiled display device of any one of claims 11 to 14, wherein the plurality of display devices are arranged in a matrix form in M rows and N columns.
